# EUROPÄISCHE PATENTSCHRIFT

(11) **EP 2 572 380 B1**
(45) Veröffentlichungstag und Bekanntmachung des Hinweises auf die Patenterteilung: **16.06.2021**
(21) Anmeldenummer: 10737473.8
(22) Anmeldetag: 20.05.2010
(51) Int. Cl.: H01L 23/31, H01L 21/56, H01L 23/538, H01L 21/683, H01L 25/065

(54) **VERFAHREN ZUR HERSTELLUNG VON CHIPSTAPELN SOWIE EIN TRÄGER FÜR DIE DURCHFÜHRUNG DES VERFAHRENS**
METHOD FOR PRODUCING CHIP STACKS AND A CARRIER FOR CARRYING OUT THE METHOD
PROCÉDÉ DE FABRICATION D'EMPILEMENTS DE PUCES AINSI QUE SUPPORT POUR LA MISE EN OUVRE DU PROCÉDÉ

(43) Veröffentlichungstag der Anmeldung: 27.03.2013
(73) Patentinhaber: Ev Group E. Thallner GmbH, 4782 St. Florian am Inn (AT)
(72) Erfinder: WIMPLINGER, Markus, AT- 4910 Ried im Innkreis (AT)
(74) Vertreter: Schneider, Sascha
(86) Internationale Anmeldenummer: PCT/EP2010/003119
(87) Internationale Veröffentlichungsnummer: WO 2011/144226

(56) Entgegenhaltungen:
- EP-A1- 2 104 138
- WO-A2-2009/094558
- None

## Beschreibung

Die vorliegende Erfindung betrifft ein Verfahren zur Herstellung von Chipstapeln gemäß Patentanspruch 1 sowie einen Träger gemäß Anspruch 12.

Druckschrift EP 2104138 A1 offenbart ein Verfahren zum Bonden von Chips auf einen Basiswafer und Druckschrift WO 2009/094558 A2 offenbart einen Träger, der an einer Trägerseite mit einer adhäsiv wirkenden Adhäsionszone sowie einer weniger adhäsiv wirkenden Stützzone versehen ist.

Die fortschreitende Miniaturisierung von auf Halbleiterchips vorliegenden Strukturen sowie durch den bestehenden Kostendruck bei der Massenfertigung von Halbleiterchips werden neuartige Verfahren und Architekturen benötigt, um die Halbleiterchips mit ihren immer kleiner werdenden Strukturen mit korrespondierenden Strukturen auf Leiterplatten oder mit benachbarten Chips zu verbinden. Dabei stellt vor allem der Größenunterschied der Strukturen und Verbindungsleitungen am Chip verglichen mit üblichen Strukturen auf Leiterplatten ein technisches Problem dar. Zwar werden auch die Strukturen der Leiterplatten weiter miniaturisiert und verfeinert, um mit dem Fortschritt der Chipfertigung mithalten zu können. Durch den bestehenden Kostendruck besteht aber ein Bedarf für die Verwendung von günstigeren Leiterplatten mit im Vergleich zu den Chipstrukturen weniger fein strukturierten Kontaktierungsstrukturen. Denn auf den Leiterplatten werden verschiedenartige Chips, insbesondere Chips mit unterschiedlichem Miniaturisierungsgrad aufzubringen, so dass bei der Fertigung der Leiterplatten durch weitere Miniaturisierung der Kontaktierungsstrukturen eine wirtschaftliche Herstellung nicht mehr möglich wäre. Die Chips mit hoher Verbindungsdichte würden die Wahl des Leiterplattenmaterials und des Fertigungsverfahrens für die Leiterplatten bestimmen.

Ein weiteres technisches Problem liegt darin, dass die Leiterplatten herkömmlicher Bauart eine thermische Dehnung aufweisen, die stark unterschiedlich zu der von Halbleitermaterialien wie Silizium, Germanium aufweisen. Um zu verhindern, dass der Unterschied in der thermischen Dehnung zwischen der Leiterplatte und dem Halbleitermaterial zu Ermüdungsbrüchen führt, sind daher in vielen Fällen auch bestimmte Mindestdimensionen der Verbindungsstrukturen (vielfach realisiert mittels sogenannter Bumps, bestehend aus zumeist eutektischen Metalllegierungen) zwischen den Chips und der Leiterplatte einzuhalten. Zur Stabilisierung von Chips in Chipstapeln oder auf der Leiterplatte müssen außerdem häufig Füllmaterialien in die Spalte eingebracht werden, was bei einer weiteren Miniaturisierung der Verbindungsstrukturen zu Problemen führt.

Unter anderem auf Grund der vorgenannten technischen Probleme werden Chips durch sogenannte Fan-Out-Kontaktierungsstrukturen hergestellt. Dabei wird ein Halbleiterchip oder Chipstapel in ein Füllematerial eingegossen, welches dazu dient, die Grundfläche des Chips zu vergrößern und damit mehr Platz für Verbindungen zur Verfügung zu haben. Die sehr dicht gepackten Anschlüsse auf dem Halbleiterchip werden dabei auf der aus dem Halbleiterchip und dem Füllermaterial bestehenden größeren Fläche aufgeweitet (Fan-Out). Die aufgeweiteten Strukturen können dann über Bumps mit einer Leiterplatte verbunden werden.

Bisherige Verfahren zur Herstellung von Chips mit Fan-Out-Kontaktierungsstrukturen basieren darauf, dass auf einen Träger ein Kleber aufgebracht wird, auf dem die Chips platziert werden. Als Kleber wird beispielsweise eine Klebefolie verwendet, die auf den Träger auflaminiert wird. Auf der Klebefolie werden die Chips mit einem Pick-and-Place-Tool aufgebracht und anschließend mit einem Schichtmaterial (Molding Compound) eingegossen. Nach dem Ablösen des so entstandenen Hybridwafers aus Chips und Schichtmaterial (Molding Compound) werden auf der Vorderseite die Fan-Out-Kontaktierungsstrukturen hergestellt.

Technische Probleme bereitet bei dem bisher bekannten Verfahren insbesondere das Lösen des Hybridwafers vom Träger, insbesondere wegen der oben beschriebenen lösbaren Klebeverbindungen. Hauptsächlich werden temporäre Verbindungen angewendet und die Klebeverbindungen reagieren häufig mit den für das Eingießen verwendeten Materialien. Bei den bisherigen Verfahren ist daher insbesondere darauf zu achten, dass die Kleber sowohl chemisch als auch mechanisch und vor allen Dingen im Hinblick auf die verwendeten Prozesstemperaturen mit dem für das Eingießen der Chips verwendeten Material kompatibel sind.

Aufgrund der verwendeten Trägermaterialien, welche üblicherweise aus einer Gruppe von Metallen, Keramik oder Halbleitermaterialien gewählt werden, scheiden UV-lösbare Kleber oder Kleber, die mittels Bestrahlung durch eine Lichtquelle, wie beispielsweise Laser, gelöst werden, aus, da diese Träger üblicherweise nicht transparent für die, zum Lösen der Kleber erforderlichen Wellenlängen sind.

Technische Probleme bereiten aber auch thermisch lösbare Kleber, wie beispielsweise doppelseitige Klebebänder oder thermisch lösbare Kleber mit einem thermoplastischen Verhalten. Die Kleber haben zumeist nicht die erforderliche Temperaturstabilität, die bei den bekannten Klebern meist bis 150° Celsius oder maximal 200° Celsius reicht. Darüber hinaus sind die Kleber bei steigender Temperatur weniger resistent gegen mechanische Verformung, wodurch Chips während des Eingießens verrutschen können und im schlimmsten Fall keinen Kontakt mehr zu den entsprechenden Kontaktierungsanschlüssen haben. Das Eingießen findet üblicherweise bei einer Temperatur zwischen 150° Celsius und 200° Celsius statt.

Ein weiteres Problem besteht darin, dass manche für das Eingießen verwendeten Materialien nur bedingt mit den verfügbaren temporären Klebern kompatibel sind, da diese mit den für das Eingießen verwendeten Materialien interagieren. Es ist daher bisher erforderlich, die Interaktion eines jeden einzelnen zur Verwendung vorgesehenen Eingießmaterials mit den verwendeten Klebern zu qualifizieren. Hierdurch wird in der Praxis die Menge an verwendbaren Materialien stark eingeschränkt, so dass weniger flexibel auf Anforderungen bei der Herstellung von Chips reagiert werden kann.

Ein weiteres Problem besteht bei der Herstellung von in mehreren Schichten von Chips gestapelten Chipstapeln, die jeweils miteinander elektrisch leitend verbunden werden sollen. Die Chipstapel, auch 3D-Packages genannt, weisen Durchkontakte (Through Silicon Vias, TSVs) auf, die ein direktes Stapeln und elektrisches Verbinden der Chips zulassen. Das Herstellen dieser elektrischen Verbindungen, welche in der Praxis zumeist metallische Lötverbindungen oder Diffusionsbondingverbindungen sind, benötigt in der Regel Temperaturen jenseits 200° Celsius, teilweise sogar bis zu 300° Celsius. Bei solchen Temperaturen versagen alle heute bekannten Kleber.

Ein weiteres technisches Problem stellt die mangelnde Transparenz der meisten bekannten Kleber hinsichtlich sichtbarem Licht dar, da insbesondere beim Platzieren der Chips mittels Pick and Place Equipment eine genaue Justierung nur bei entsprechend transparenten Klebern möglich ist. Die Justiergenauigkeit leidet daher bei manchen Klebern, so dass in besonderen Fällen auf ein sogenanntes Globales Alignment zurückgegriffen wird, bei dem die Chips in einem vordefinierten Raster unter Zuhilfenahme eines externen (nicht zum Wafer gehörenden) Referenzsystems platziert werden. Zumeist wird dieses Referenzsystem durch die Stage (Aufnahmeeinrichtung) und die zur Stage gehörende Sensorik des Pick-and-Place Systems gebildet. Dies birgt den Nachteil, dass etwaige thermische Dehnungen des gesamten Systems direkt auf die Justiergenauigkeit eingehen, so dass der Aufbau des Pick and Place Systems entsprechend robust und stabil sein muss, um derartige Einflüsse und die Neigung zu einem Drift der Justiergenauigkeit zu eliminieren. Hierdurch werden die Kosten für die Justierung deutlich erhöht.

Soweit beim Ablösen des Hybridwafers vom Träger ein thermischer oder thermomechanischer Prozess verwendet werden soll, besteht das Problem, dass auch hier die Temperatur für die Molding Compound Materialien kritisch bis nicht tolerierbar ist. Die Materialien verlieren beim Erhitzen die mechanische Stabilität, was ein Ablösen vom Träger im erhitzten Zustand zumindest erschwert. Dabei kann auch die Justiergenauigkeit der einzelnen Chips im Raster beeinträchtigt werden, die aber Voraussetzung für ein erfolgreiches weiteres Prozessieren der Hybridwafer ist. Beispielsweise sollen im Anschluss die sehr dicht gepackten Verbindungspads auf den einzelnen Chips mit Kontakten kontaktiert werden, die in Dünnschichttechnik mittels Lithografie definiert werden. Prekärerweise sind hier die Kontakte, die die feinsten Strukturgrößen benötigen, am kritischsten, und zwar deshalb, weil die direkt an den Chips vorgesehenen Kontakte die feinste Auflösung und die größte Dichte im Vergleich zu den weiteren Lagen aufweisen, während die Chips die größte Variation hinsichtlich lateraler (X-Y-Ebene) Justiergenauigkeit aufweisen. Die weiteren Verbindungslagen benötigen im Vergleich zu der ersten, hoch auflösenden Lage hinsichtlich lateraler Positionsgenauigkeit der einzelnen Strukturen eine viel geringere (Faktor 2 bis Faktor 5) laterale Positionsgenauigkeit als die Chips.

Zusammengefasst bestehen daher die folgenden Probleme:
- chemische Stabilität der verwendeten Kleber
- thermische Stabilität der verwendeten Kleber
- thermomechanische Stabilität der verwendeten Kleber
- mangelnde Transparenz der verwendeten Kleber (Justiergenauigkeit)
- Justiergenauigkeit der Chips (verschwimmen)
- Temperatur beim Ablöseprozess

Der Erfindung liegt daher die Aufgabe zugrunde, ein Verfahren zur Herstellung von Chipstapeln mit Fan-Out-Kontaktierungsstrukturen anzugeben, mit welchem die vorgenannten Einschränkungen hinsichtlich der thermischen Stabilität, thermomechanische Stabilität und/oder chemischen Kompatibilität des Trägers mit den zum Aufbau des Hybridwafers verwendeten Materialien und sich anschließenden Prozessen nicht mehr vorliegen. Eine weitere Aufgabe besteht darin, die Justiergenauigkeit beim Platzieren und beim Aufbau der Chips zu erhöhen und möglichst gleichzeitig die Kosten bei der Herstellung zu reduzieren.

Diese Aufgabe wird mit den Merkmalen der Ansprüche 1 und 12 gelöst. Vorteilhafte Weiterbildungen der Erfindung sind in den Unteransprüchen angegeben.

Der Erfindung liegt der Gedanke zugrunde, die aus mindestens einer Chiplage bestehenden Chipstapel nicht mehr direkt auf einen Träger zu kleben, sondern auf den Träger zunächst eine, insbesondere dielektrische beziehungsweise isolierende und/oder fotostrukturierbare, Basisschicht aufzubringen, auf die wiederum der Chipstapel aufgebaut wird. Mit Vorteil ist es erfindungsgemäß insbesondere denkbar, dass die Basisschicht zumindest teilweise Bestandteil der Chipstapel beziehungsweise des zu erzeugenden Hybridwafers wird. Insbesondere kann auf teure temporäre Kleber zumindest weitgehend verzichtet werden.

Erfindungsgemäß wird die Basisschicht auf den Träger zumindest überwiegend auf eine Stützzone mit reduzierter Haftkraft aufgebracht, wobei die Stützzone den Großteil der Fläche des zu erzeugenden Hybridwafers beziehungsweise einen Großteil der Fläche des Trägers umfasst. Erfindungsgemäß ist es dabei denkbar, dass nur die am äußersten Rand des zu erzeugenden Hybridwafers beziehungsweise der zu erzeugenden Chipstapel eine Adhäsionszone mit hoher Haftkraft/Adhäsionskraft am Träger vorgesehen ist. Mit anderen Worten: Der Träger hält die Basisschicht und die auf der Basisschicht aufzubauenden Chipstapel aus mindestens einer Lage Chips quasi ausschließlich am Umfang der Basisschicht, wobei die Kontaktfläche zwischen der Basisschicht und dem Träger eben ist.

Die Adhäsionskraft der Adhäsionszone auf die Basisschicht ist erfindungsgemäß pro Fläche insbesondere mindestens dreimal, vorzugsweise mindestens fünfmal, noch bevorzugter mindestens zehnmal, idealerweise mindestens zwanzigmal stärker als die Adhäsionskraft der Stützzone.

Als Träger können jegliche, für die Herstellung des Hybridwafers beziehungsweise der Stückchipstapel geeigneten Materialien verwendet werden, wobei besonders bevorzugte Materialien jene sind, die aus einer der Gruppen Metall, Keramik oder Halbleiter, sowie Quarz, Glas oder dergleichen gewählt sind. Es ist auch denkbar, einen Träger bestehend aus einer Kombination dieser Materialien herzustellen. Der Träger kann eine beliebige Form aufweisen, ist mit Vorteil jedoch quadratisch, rechteckig oder insbesondere kreisförmig. Besonders vorteilhaft ist eine Ausführungsform eines Trägers in Form eines kreisförmigen Substrats mit Dimensionen ähnlich oder identisch zu Standardsiliziumwafern, da in diesem Fall auf etablierte, verfügbare Fertigungsmaschinen und Infrastruktur zurückgegriffen werden kann.

Der Kern der Erfindung besteht also in dem Aufbringen einer Basisschicht auf einem Träger, die im Vergleich zu dem für das Eingießen des Chipstapels verwendeten Material sowohl in chemischer als auch in thermischer Hinsicht und in thermomechanischer Hinsicht bessere Eigenschaften aufweist, insbesondere in Verbindung mit der durch die Fixierung am Rand der Basisschicht deutlich vereinfachten Ablösung des Trägers von der Basisschicht. Sowohl die Flexibilität als auch die erreichbare Justiergenauigkeit sind aufgrund der Basisschicht, die nicht von einem Schichtmaterial (Molding Compound) eingegossen wird, deutlich verbessert. Weiterhin werden die Herstellungskosten durch Verzicht auf teure Materialkombinationen, insbesondere in Hinblick auf temporäre Kleber, verbessert. Schließlich und nicht zuletzt wird erst durch die vorliegende Erfindung die Möglichkeit geschaffen, mehrere Chiplagen zu Chipstapeln mit die Chips/Chipstapel elektrisch verbindenden Leiterbahnen, insbesondere Fan-Out-Kontaktierungsstrukturen, zu verarbeiten.

In einer weiteren, eigenständigen nicht beanspruchten Ausgestaltung ist vorgesehen, dass die Basisschicht durch ein Prägeverfahren, beispielsweise Heißprägen oder UV Prägeverfahren (basierend auf Materialien die durch Bestrahlung mittels Ultraviolett Licht vernetzbar sind) strukturierbar ist, insbesondere aus Kunststoff besteht, zur Erzeugung von aus mindestens einem Kunststoffchip ausgebildeten Chipstapeln. Hierbei ist es denkbar, erfindungsgemäß auf Silizium gänzlich zu verzichten. Die Ausführungsform wäre insbesondere für Anwendungen der Mikrofluidik, also die Herstellung eines Mikrofluidikchips vorteilhaft und zeigt eindrucksvoll die Vielseitigkeit des erfindungsgemäßen Verfahrens. Der Verfahrensschritt des Aufbauens der Chipstapel besteht dann in der allgemeinsten Ausführung dieser Variante ausschließlich darin, dass die Basisschicht, insbesondere durch ein Prägeverfahren wie beispielsweise Heißprägen oder ein UV Prägeverfahren, strukturiert wird und gegebenenfalls eine Metallisierung und / oder Verkapselung der Strukturen mittels eines darauffolgenden Bondverfahrens erfolgt.

Derartige Prägeverfahren können auch für eine besonders kostengünstige Herstellung von elektrischen Verbindungen, die durch das Molding Compound reichen (so genannte Through Mold Vias oder kurz TMV), verwendet werden. Dabei wird das Eingießen der Chips in einer Art und Weise durchgeführt, in der das Eingießwerkzeug die gewünschten Strukturen, beispielsweise zum Herstellen von Durchlöchern im Molding Compound, aufweist. Während dem Eingießvorgang wird das Eingießwerkzeug in die flüssige Molding Compound Masse gepresst und die, in das Werkzeug eingearbeiteten Negativstrukturen verdrängen das Molding Compound an den vorgesehenen Stellen. Nach dem Aushärten des Molding Compound Materials bleiben die gewünschten Positivstrukturen im ausgehärteten Molding Compound Material zurück. Auf diese Art und Weise können beispielsweise Durchlöcher hergestellt werden, die im Anschluss zur gegebenen Zeit im Fertigungsprozessfluss mit industrieüblichen Verfahren, insbesondere beispielsweise elektrochemischer Abscheidung von Metallen gefüllt werden können. Dies kann sich als besonders nützlich erweisen für Anwendungsfälle, wo beispielsweise zwei, auf diese Art und Weise hergestellte Chipstapel wiederum gestapelt und elektrisch miteinander verbunden werden sollen. Die, auf die soeben beschriebenen Art und Weise hergestellten TMV Kontakte ermöglichen ein einfaches und platzsparendes elektrisch leitfähiges Verbinden der beiden Chipstapel.

Erfindungsgemäß ist vorgesehen, dass an der Trägerseite in der Adhäsionszone ein selektiv lösbares Füllmaterial vorgesehen ist, auf einem gegenüber der Trägerseite zurückgesetzten Absatz, flächenbündig auffüllend zur Trägerseite. Durch diese Maßnahme wird das Ablösen des Trägers von dem Hybridwafer beziehungsweise den Chipstapeln auf besonders schonende Art und Weise ermöglicht, indem das Füllmaterial selektiv durch entsprechende Lösungsmittel gelöst wird, die in Hinblick auf die weiteren Materialien entweder unselektiv sind oder von diesem zumindest weitgehend abschottbar sind.

Indem die Basisschicht vollflächig auf die Stützzone und zumindest teilweise auf die Adhäsionszone aufgebracht wird, ist die auf dem Träger verfügbare Fläche nahezu vollständig für die Herstellung der Chipstapel nutzbar. Bei einem Trägerdurchmesser von 300 mm beträgt der Abstand, insbesondere die Ringbreite, vom Rand der Adhäsionszone bis zum Rand der Stützzone zwischen 0,5 mm und 10 mm, insbesondere zwischen 1 mm und 5 mm, vorzugsweise zwischen 2 mm und 4 mm.

Gemäß einer weiteren vorteilhaften Ausführungsform der Erfindung ist vorgesehen, dass die Chipstapel vor dem Lösen des Trägers vereinzelt werden, insbesondere durch Schneiden, so dass die Chipstapel nur noch mit dem Träger verbunden sind. Dabei wird gleichzeitig die Basisschicht in den Chipstapeln zugeordnete Basisteile geschnitten.

Besonders vorteilhaft ist eine Ausführungsform, bei der das die Basisschicht bildende Material flexibel ist, insbesondere in Verbindung mit der Maßnahme, dass statt dem Eingießen mit einem Schichtmaterial (Molding Compound) zum Eingießen das die Basisschicht bildende Material verwendet wird. Hierdurch wird es ermöglicht, besonders dünne und kompakte Packages herzustellen, die einerseits eine sehr hohe mechanische Robustheit aufweisen und andererseits mechanisch flexibel (biegsam) sind. Dies ist besonders vorteilhaft für spezielle Anwendungen, wo die Flexibilität wichtig ist, insbesondere Smartcards oder bei späterer Anbringung der Packages auf eine gebogene Fläche.

Gemäß einer besonders vorteilhaften Ausführungsform der Erfindung ist vorgesehen, dass, insbesondere vor dem Aufbauen der Chipstapel, Fan-Out-Kontaktierungsstrukturen in die Basisschicht eingebracht werden. Hierdurch wird die Basisschicht zu einem weiteren Zweck verwendet und bildet somit einen weiteren funktionalen Bestandteil der Chipstapel beziehungsweise des Hybridwafers. Besonders vorteilhaft ist in diesem Fall auch die Möglichkeit, diese Fan-Out-Kontaktierungsstrukturen vor dem Platzieren der Chips Qualitätstests zu unterziehen, womit verhindert werden kann, dass etwaige Fehler in diesen Strukturen dazu führen, dass Chips oder Chipstapel auf nicht-funktionale Fan-Out-Kontaktierungsstrukturen aufgebracht werden.

Die Fan-out-Kontaktierungsstrukturen erweitern dabei die verfügbare fan-out-Kontaktfläche im Verhältnis zur Chipkontaktfläche des jeweils korrespondierenden Chips, insbesondere mindestens um den Faktor 1,5, vorzugsweise Faktor 2, noch bevorzugter Faktor 3, idealerweise Faktor 4.

Besonders vorteilhaft ist es dabei, wenn vor dem Aufbauen der Chipstapel an einer Trägerseite abgewandten Chipseite Kontaktpads zur elektrischen Kontaktierung der Chipstapel mit den Fan-Out-Kontaktierungsstrukturen aufgebracht werden.

Weiterhin ist es von Vorteil, vor oder beim Aufbauen der Chipstapel, insbesondere gleichzeitig mit dem Einbringen der Kontaktierungsstrukturen, Justiermarken zur Positionierung der Kontaktpads und/oder der Chipstapel auf der Basisschicht, insbesondere jeweils fluchtend zu einem Rand der Chipstapel, in/auf der Basisschicht vorzusehen. Alternativ können diese Justiermarken mit, auf den einzelnen Chips befindlichen Justiermarken korrespondieren. Auf diese Weise erfüllt die Basisschicht eine weitere, zusätzliche Funktion und durch die vorbeschriebene Maßnahme wird die Justiergenauigkeit der Chips/Chipstapel weiter erhöht. Besonders vorteilhaft ist es, wenn die Basisschicht ein fotostrukturierbares Material, insbesondere ein fotostrukturierbares Dielektrikum ist.

Gemäß einer alternativen, eigenständigen erfindungsgemäßen Ausführungsform ist vorgesehen, dass die Chipstapel durch Kleben direkt auf die Basisschicht aufgeklebt werden. Dies kann entweder unter Zuhilfenahme eines zusätzlichen Klebers geschehen oder unter Nutzung etwaiger Klebeeigenschaften des Materials der Basisschicht. So ist es erfindungsgemäß denkbar, dass die Chips mittels eines sogenannten Die Attach Adhesives verklebt werden. Alternativ ist es denkbar, dass das Material der Basisschicht ein Dielektrikum ist, welches im unbelichteten Zustand weitgehend das Verhalten eines Thermoplasts hat. Damit sind die Chips mittels eines thermomechanischen Klebeverfahrens fixierbar.

Es ist besonders vorteilhaft, wenn nach dem Aufbauen der Chipstapel und vor dem Lösen des Trägers die Chipstapel eingegossen werden, insbesondere mit einem der Basisschicht entsprechenden Schichtmaterial, da hierdurch besonders flexible und gleichzeitig stabile Chipstapel beziehungsweise Hybridwafer ausgebildet werden können.

Gemäß der Erfindung ist vorgesehen, dass das Lösen des Trägers von einem Seitenrand des Trägers her, Verringerung der Adhäsionskraft der Adhäsionsschicht, durch selektives Lösen des Füllmaterials, erfolgt. Durch diese erfindungsgemäße Maßnahme wird das Ablösen des Trägers von der Basisschicht und dem auf der Basisschicht aufgebrachten Chipstapeln auf, insbesondere für das Eingießmaterial, schonende Art und Weise realisiert.

Das Lösen des Trägers von der Basisschicht erfolgt erfindungsgemäß durch Verbindungslösemittel, die insbesondere an der Adhäsionszone und die in der Adhäsionszone zwischen der Basisschicht und dem Träger wirkenden Adhäsionsmittel einwirken.

Als Verbindungslösemittel können Fluidmittel, insbesondere ein die Verbindung selektiv auflösendes Lösungsmittel, vorgesehen sein. Die chemische Auflösung ist besonders schonend und bei entsprechender Materialwahl kann die Auflösung auch sehr schnell erfolgen, insbesondere wenn nur Randbereiche des Trägers beziehungsweise der Basisschicht mit einer Adhäsionsschicht versehen sind, so dass das Lösungsmittel von der Seite her schnell wirken kann.

Gemäß einer nicht beanspruchten Alternative ist vorgesehen, dass das Verbindungslösemittel mechanische Trennmittel, insbesondere eine Klinge zum mechanischen Trennen der Basisschicht von dem Träger in der Adhäsionszone, zur Lösung der Adhäsion umfasst. Denkbar ist auch eine Kombination aus mechanischen Trennmitteln und Fluidmitteln.

In einer weiteren, nicht beanspruchten Alternative ist vorgesehen, dass als Verbindungslösemittel eine UV-Lichtquelle zur Lösung der Adhäsion zwischen der Basisschicht und dem Träger umfasst. Auch diese Ausführungsform ist mit der Ausführungsform der mechanischen Trennmittel und/oder der Ausführungsform mit Fluidmitteln kombinierbar.

Soweit das Verbindungslösemittel, insbesondere ausschließlich, von einem Seitenrand des Trägers wirkend ausgebildet ist, kann oft eine Einwirkung auf den Träger und/oder den Hybridwafer/die Chipstapel von der Oberseite und/oder der Unterseite, insbesondere einem innerhalb des Seitenrandes des Trägers oder in der Stützzone liegenden Bereich des Trägers, verzichtet werden.

Indem eine Rotationseinrichtung zur Rotation des Trägers vorgesehen ist, kann auf eine Anordnung der Verbindungslösemittel über den gesamten Umfang des Trägers verzichtet werden und eine teilweise Beaufschlagung am Umfang des Trägers ist ausreichend.

Mit Vorteil ist zur Beaufschlagung der Adhäsionsschicht mit Fluidmitteln zur Aufnahme des Fluidmittels ein am Träger oder einer Trägeraufnahme, insbesondere gedichtet, angeschlagener Lösungsmittelbehälter vorgesehen. Indem der Lösungsmittelbehälter den Seitenrand beziehungsweise Umfang des Trägers zumindest teilweise umgreift, ist eine besonders effektive Einwirkung auf die Verbindungsschicht möglich. Weiterhin kann durch die Maßnahme des Umgreifens verhindert werden, dass Fluidmittel aus dem Lösungsmittelbehälter austritt oder UV-Licht-Intensität verloren geht. Beim Einsatz von mechanischen Trennmitteln wird vermieden, dass etwaige Verunreinigungen aus dem Lösungsmittelbehälter austreten und den Hybridwafer oder die Chipstapel verunreinigen. Der Lösungsmittelbehälter kann in vorteilhafter Ausgestaltung im Querschnitt L- oder U-förmig ausgebildet sein.

Das Auflösen der Adhäsionsschicht, insbesondere des selektiv lösbaren Füllmaterials, ist durch einen Schallgeber beschleunigbar, der die Ablösung des Trägers durch mittels ultra- oder megaschallerzeugter Kavitation deutlich beschleunigt, so dass das Ablösen wesentlich schonender und gleichzeitig schneller erfolgt. Der Schallgeber ist dabei mit dem verwendeten Lösungsmittel in Kontakt, um eine optimale Schallübertragung zu gewährleisten. Mit Vorteil ist der Schallgeber in den L- oder U-förmigen Lösungsmittelbehälter mechanisch integriert. Alternativ kann der Schallgeber auch in das Lösungsmittel eingetaucht werden, sobald das Lösungsmittel zum Trennen der Adhäsionsschicht in der vorgesehenen Art und Weise zugeführt wurde.

Die vorliegende Erfindung betrifft außerdem einen Träger nach Anspruch 12. Mit einem so ausgestatteten Träger ist das erfindungsgemäße Verfahren in besonders vorteilhafter Weise ausführbar, da das Lösen des Hybridwafers beziehungsweise der Chipstapel von dem Träger zumindest weitgehend ohne Beeinträchtigung der Chipstapel und der molding compound erfolgt. Hierdurch wird ein besonders schonendes Lösen der teuren Chipstapel gewährleistet. Es ist außerdem denkbar, mehrere benachbarte Chipstapel beim Aufbauen der Chipstapel und/oder der Erstellung der Fan-out-Kontaktierungsstrukturen zu Chipstapelstrukturen (siehe Ausführungsform F) zusammenzuschalten.

Mit Vorteil ist weiterhin möglich, dass die Ablösung des Trägers konzentrisch vom Umfang des Trägers zum Zentrum des Trägers erfolgt.

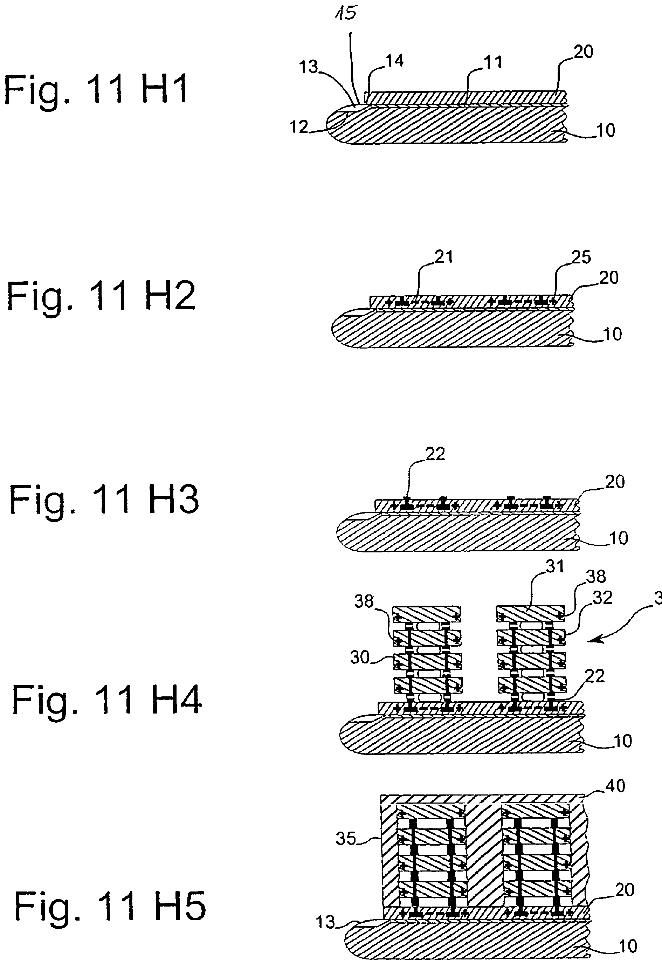

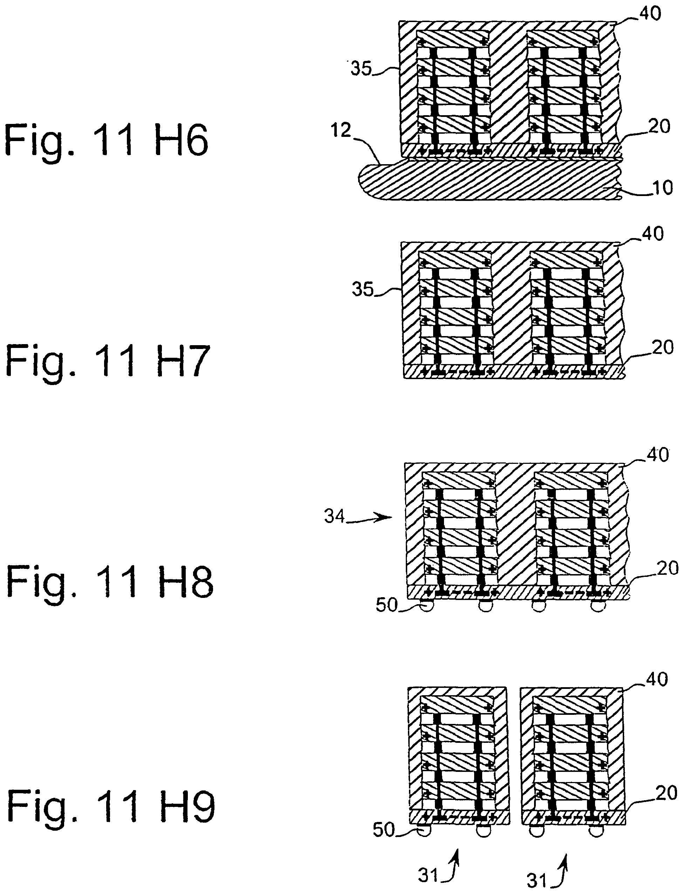

Weitere Vorteile, Merkmale und Einzelheiten der Erfindung ergeben sich aus der nachfolgenden Beschreibung sowie anhand der Zeichnungen. Erfindungsgemäße Ausführungsformen werden in den Figs. 11H1 - 11H9 gezeigt. Alle anderen Figs. zeigen nicht beanspruchte Beispiele.
- Fig. 1A bis 1E, 9F1, 10G1 und 11H1:: eine schematische Ansicht eines Schritts des Aufbringens einer Basisschicht auf einen Träger gemäß Ausführungsformen A bis H,
- Fig. 2A bis 2E und 11H2:: eine schematische Ansicht eines Schritts der Einbringung von fan-out-Kontaktierungsstrukturen sowie Justiermarken in die Basisschicht gemäß Ausführungsformen A bis E und H,
- Fig. 3A bis 3E und 11H3:: eine schematische Ansicht eines Schritts des Platzierens von Kontaktpads auf die Basisschicht gemäß Ausführungsformen A bis E und H,
- Fig. 4A bis 4E, 9F2, 10G4 und 11H4:: eine schematische Ansicht eines Schritts der Stapelung von Chips auf die Basisschicht in mindestens einer Lage gemäß Ausführungsformen A bis H,
- Fig. 5A bis 5E, 10G5 und 11H5:: eine schematische Ansicht eines Schritts des Eingießens der Chipstapel mit molding compound gemäß Ausführungsformen A bis E, G und H,

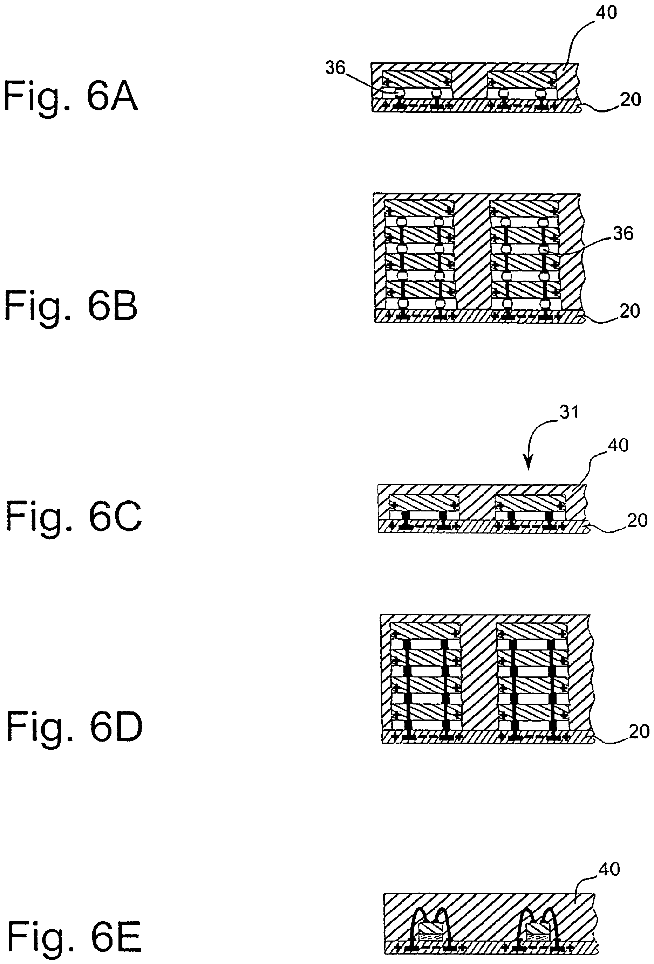

- Fig. 6A bis 6E, 9F6, 10G6 und 11H7:: eine schematische Ansicht eines Schritts des Lösens der Basisschicht mit Chipstapel von dem Träger gemäß Ausführungsformen A bis H,

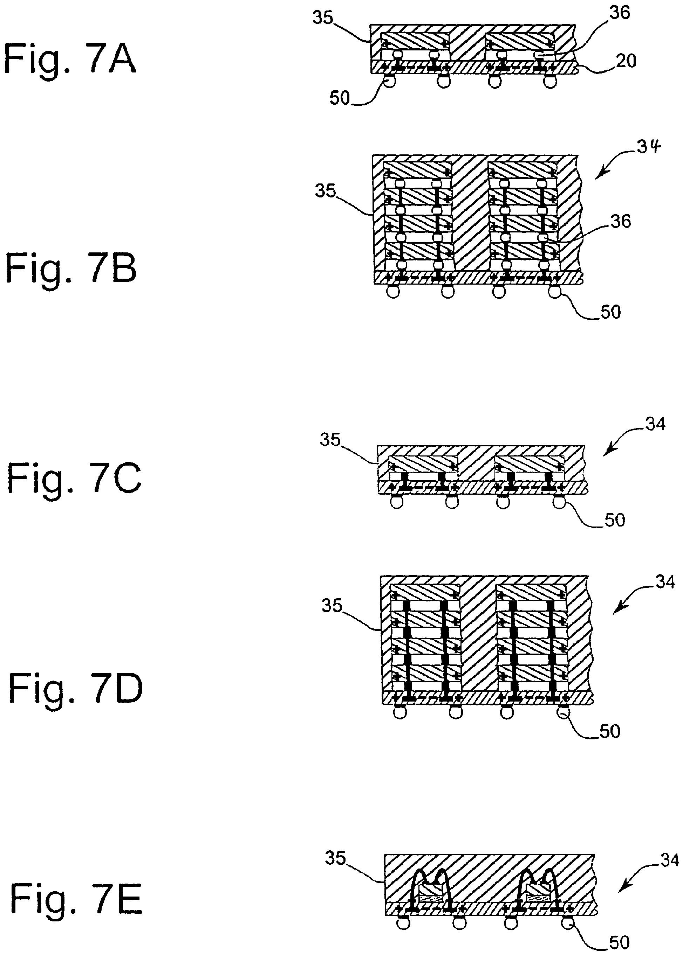

- Fig. 7A bis 7E, 10G10 und 11H8:: eine schematische Ansicht eines Schritts des Aufbringens von Lötanschlüssen (bumps) gemäß Ausführungsformen A bis E, G und H,

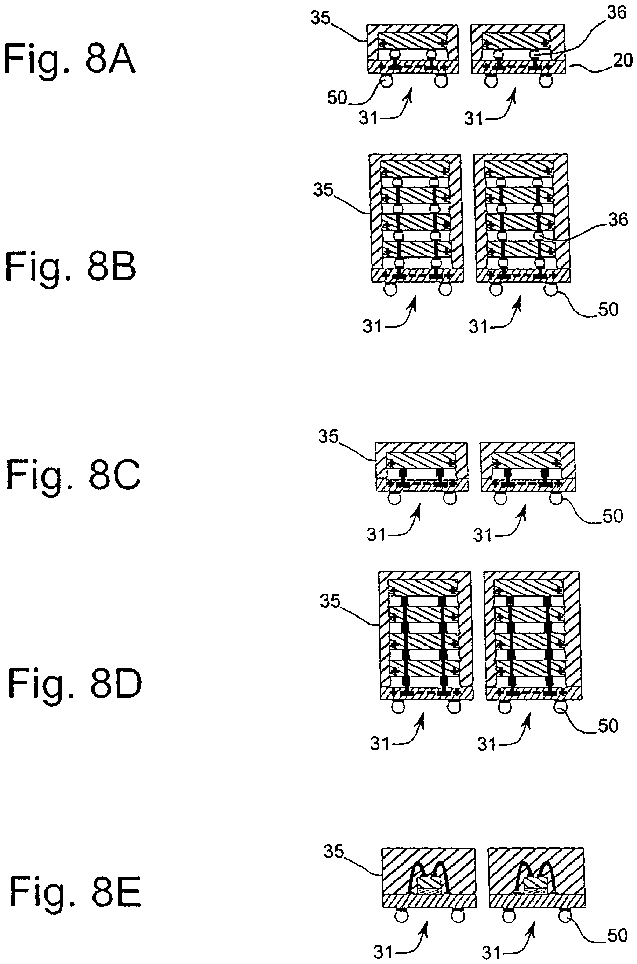

- Fig. 8A bis 8E, 9F7, 10G11 und 11H9:: eine schematische Ansicht eines Schritts des Vereinzelns der Chipstapel beziehungsweise des Hybridwafers auf dem Träger gemäß Ausführungsformen A bis H,
- Fig. 9F3:: eine schematische Ansicht eines Schritts des Eingießens mit einem der Basisschicht entsprechenden Schichtmaterial gemäß Ausführungsform F,

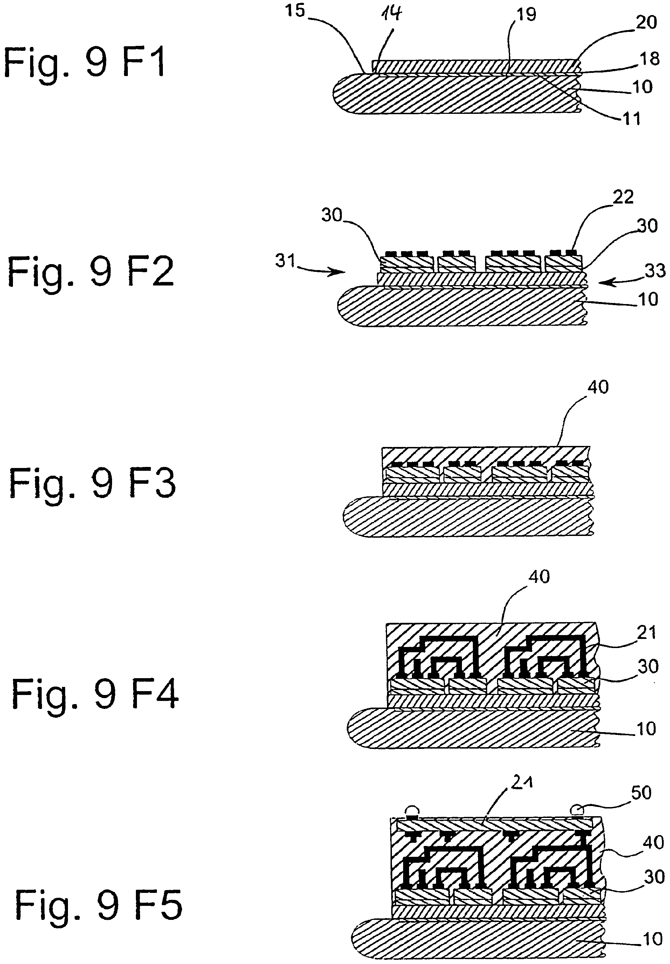

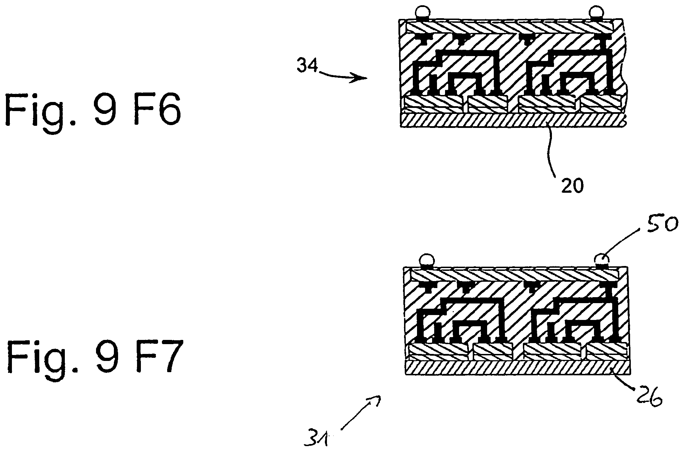

- Fig. 9F4:: eine schematische Ansicht eines Schritts des Einbringens von fan-out-Kontaktierungsstrukturen gemäß Ausführungsform F,
- Fig. 9F5:: eine schematische Ansicht eines Schritts des Aufbringens einer weiteren Chiplage und von Lötanschlüssen (bumps) gemäß Ausführungsform F,

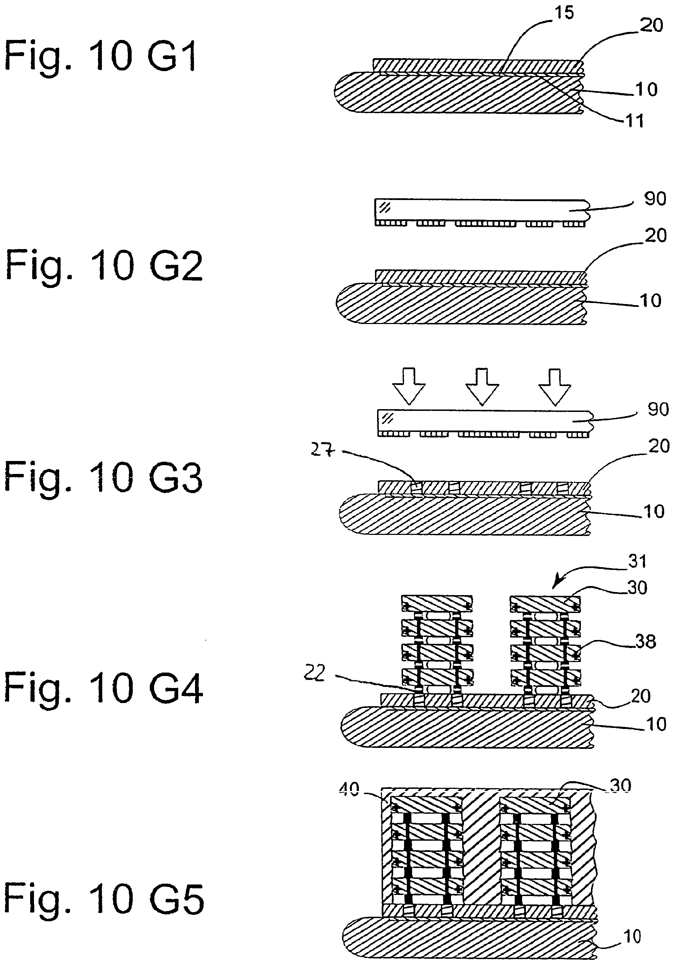

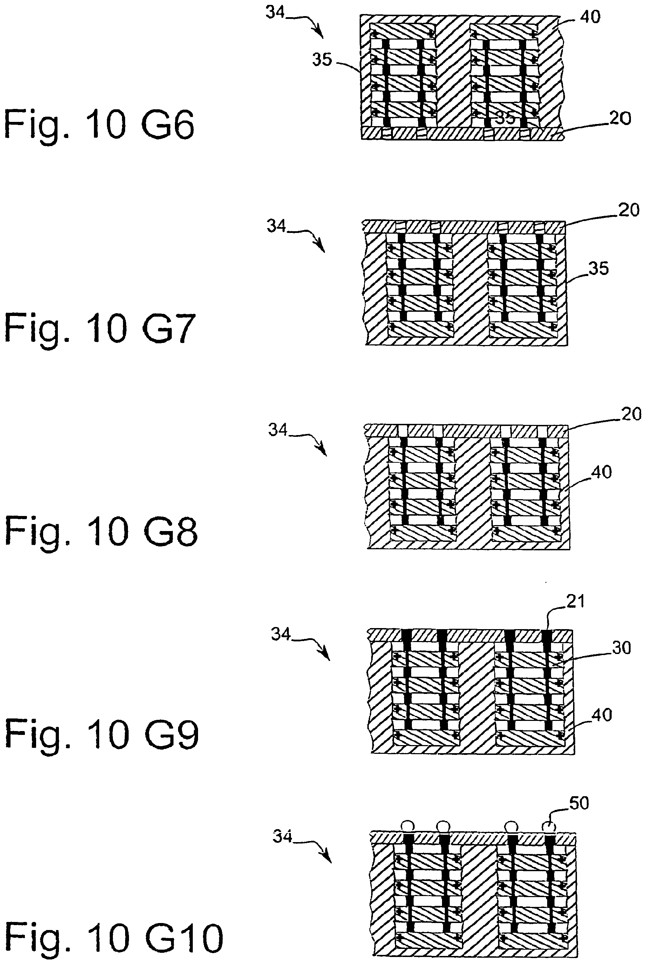

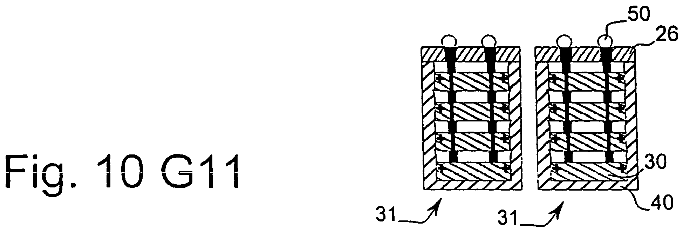

- Fig. 10G2:: eine schematische Ansicht eines Lithographieschritts gemäß Ausführungsform G,
- Fig. 10G3:: eine schematische Ansicht eines Lithographieschritts gemäß Ausführungsform G,
- Fig. 10G7: eine schematische Ansicht eines Schritts zur Umdrehung des Hybridwafers um 180° gemäß Ausführungsform G,
- Fig. 10G8: eine schematische Ansicht eines Ätzschritts gemäß Ausführungsform G,
- Fig. 10G9: eine schematische Ansicht eines Schritts des Einbringens von fan-out-Kontaktierungsstrukturen gemäß Ausführungsform G,
- Fig. 11H6:: eine schematische Ansicht eines Schritts des Lösens eines Füllmaterials gemäß Ausführungsform H,

In den Figuren sind einzelne oder mehrfache Schritte der Ausführungsformen A bis H gezeigt, wobei die Figurenbezeichnung jeweils mit den Referenzzeichen A bis H gekennzeichnet ist. Die einzelnen Schritte der Ausführungsformen A bis E sind jeweils gemeinsam auf einer Seite dargestellt, während die Schritte der Ausführungsformen F, G und H jeweils für sich als Folge dargestellt sind.

Die Darstellung erfolgt ohne die an sich bekannten Vorrichtungen zur Handhabung des Trägers und/oder zur Durchführung der einzelnen Schritte. Die Bezugszeichen sind einheitlich für die korrespondierenden Bauteile verwendet, auch wenn bei den unterschiedlichen Ausführungsformen verschiedene Maßnahmen/Materialen gewählt werden.

Das Schlüsselthema bei der vorliegenden Erfindung ist, dass temporäre Kleber (temporary adhesives) zur Fixierung von Chips 30 oder Chipstapeln 31 entweder gänzlich oder zumindest weitgehend vermieden werden. Anstatt dessen werden Träger 10 verwendet, die eine Stützzone 11 mit reduzierter Haftkraft/Adhäsionskraft auf eine Kontaktfläche 18 zwischen dem Hybridwafer 34 und dem Träger 10 aufweisen. Diese Stützzone 11 mit reduzierter Haftkraft kontaktiert den Großteil der Fläche des zu erzeugenden Hybridwafers 34, der wiederum aus einer Vielzahl von Chipstapeln 31 mit jeweils mindestens einer Chiplage 33 besteht. Das System ist so gestaltet, dass nur die am äußersten Hybridwaferrand 35 des zu erzeugenden Hybridwafers 34 befindliche, insbesondere ringförmige, Teilfläche der Kontaktfläche 18 auf einer Adhäsionszone 14 mit hoher Haltekraft/Adhäsionskraft auf die Kontaktfläche 18 am Träger 10 zu liegen kommt.

Als Träger 10 können jegliche, für die Herstellung des Hybridwafers 34 geeignete Materialien verwendet werden. Typischerweise kommen jedoch Materialien selektiert aus einer der Gruppen Metall, Keramik oder Halbleiter, sowie Quartz, Glas oder dergleichen zum Einsatz. Der Träger 10 weist bei den gezeigten Ausführungsformen eine kreisförmige Form auf und ist als Standardwafer mit 300mm Durchmesser ausgebildet.

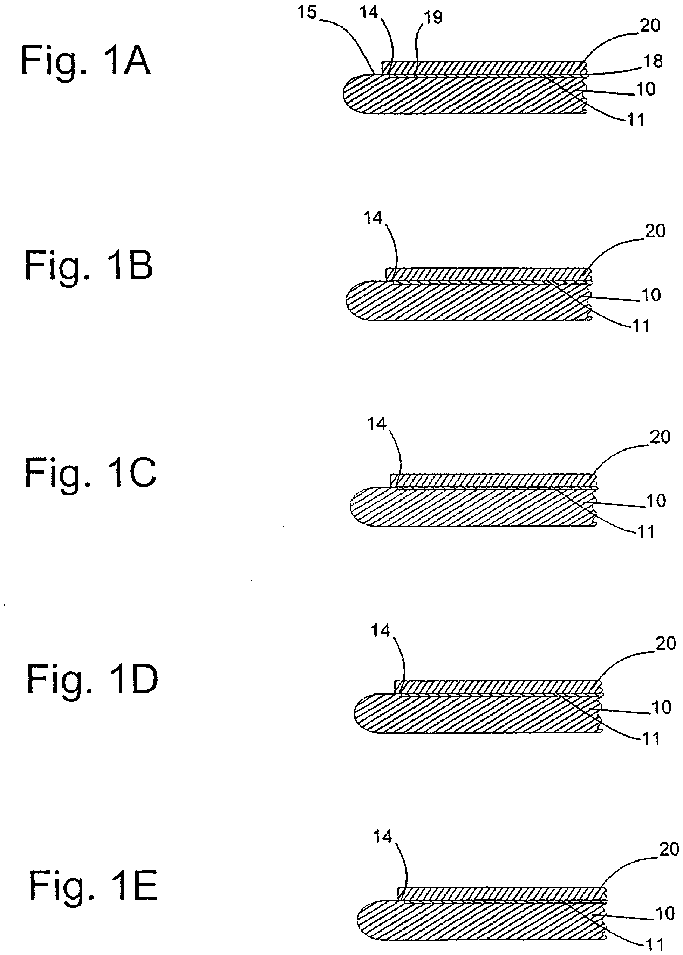

Die Stützzone 11 des Trägers 10 ist gebildet durch eine Füllschicht 19 (siehe Fig. 1A), die flächenbündig zur Trägerseite 15 in den Träger eingebracht ist. Die Dicke der Füllschicht 19 beträgt mindestens 3 µm bis 100µm, vorzugsweise 10µm bis 50µm.

Die Aufbringung/Einbringung der Füllschicht 19 erfolgt beispielsweise durch spin coating. Die Füllschicht 19 besteht insbesondere aus einem Material mit 5 bis 50 Gew.-% Feststoffen, insbesondere 15 bis 30 Gew.-%, wobei die Feststoffe gewählt sind aus der Gruppe der Monomere, Oligomere und/oder Polymere, vorzugsweise zyklische Olefinpolymere und/oder CoPolymere und/oder amorphe Fluoropoolymere mit hohem atomarem Fluorgehalt, insbesondere mehr als 30 Gew.-%, vorzugsweise mehr als 45 Gew.-%.

In anderen Worten: Die Füllschicht 19 weist eine oder mehrere der nachfolgend beschriebenen Eigenschaften auf:
- Sie besteht insbesondere aus amorphen Polymermaterialen mit niedriger freier Oberflächenenergie,
- Sie ist gering bis nicht haftend in Bezug auf Silikon, Glass und/oder Metalloberflächen, indem die Füllschicht 19 zumindest an der Oberfläche eine geringe bis sehr geringe Konzentration an Hydroxyl- oder Carbonsäuregruppen,
- Ist aus einer Lösung formbar,

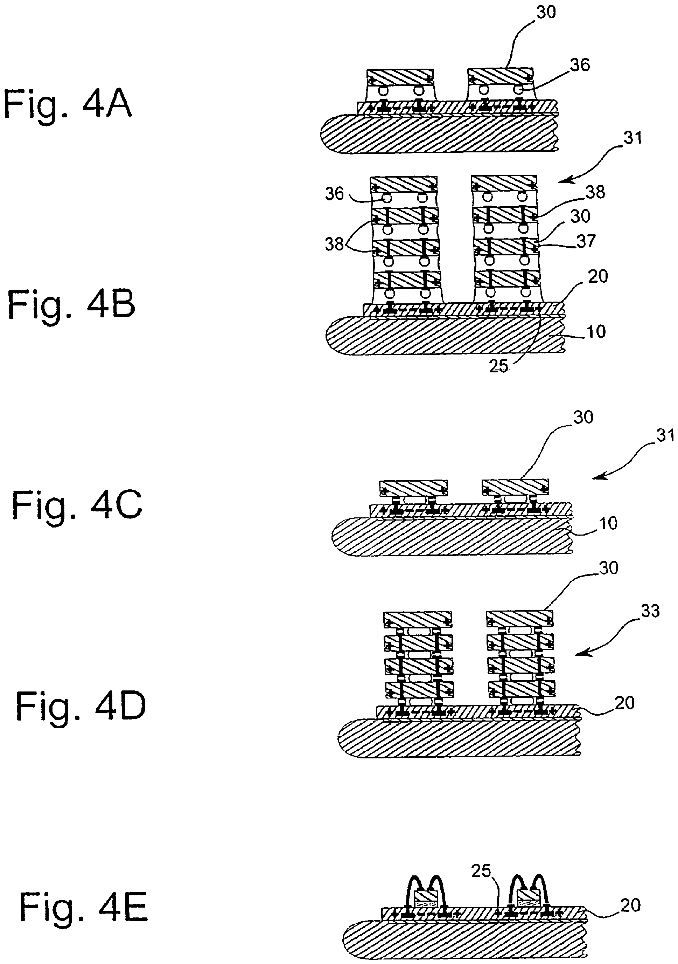

Das Stapeln der Chips 30, insbesondere in mehreren Lagen ist dem Fachmann bekannt. Bei der Ausgestaltung wird das Stapeln verbessert, indem jeder Chip 30, insbesondere am Chiprand 37, Chipjustiermarken 38 aufweist, die zur Justierung der Chips 30 gegenüber den Justiermarken 25 der Basisschicht 20 dienen (siehe Fig. 4B).Die Stützzone 11 ist alternativ herstellbar oder an ihrer Oberfläche behandelbar durch nachfolgend aufgeführte Schritte:
- Chemische Behandlung der aus Silikon gebildeten Oberfläche mit einem hydrophoben Organosilan, wie beispielsweise (Fluor-)Alkyl-Phosophonat oder (Fluor-)Alkyl-Silan zur Reduzierung der freien Oberflächenenergie, oder
- Chemische Gasphasenabscheidung (CVD-Verfahren) einer Beschichtung mit geringer freier Oberflächenenergie (beispielsweise fluorierte Parylene) auf den Träger, um eine dauerhafte Antihaftbeschichtung in der oder als Stützzone zu erzeugen,

Die Dicke einer solchen Beschichtung liegt insbesondere zwischen 1nm und 20nm, vorzugsweise zwischen 2nm und 10nm.

Die Herstellung einer solchen, durch chemische Modifikation von zumindest Teilen der Oberfläche des Trägers 10 hergestellten Sützzone 11 läuft, als veranschaulichendes, nicht beanspruchtes Beispiel, wie folgt ab:
Ein epoxybasierter Photolack wird auf eine Oberfläche eines Silikonwafers (Träger 10) mit einem Durchmesser von 300mm in einem ringförmigen Abschnitt (Adhäsionszone 14) am äußeren Umfang des Silikonwafers aufgebracht. Die Ringbreite beträgt zwischen 1 und 10mm. Ein fluoriertes Silan wird mit einem geeigneten Lösungsmittel zu einer einprozentigen Lösung verdünnt. Die Lösung wird durch Spinbelacken auf die Oberfläche des Silikonwafers aufgebracht. Anschließend wird der Wafer für eine Minute auf einer Heizplatte bei 100°C gehärtet. Daraufhin wird der Wafer in einem Spin coater gespült und erneut für eine Minute bei 100°C gehärtet. Der epoxybasierte Photolack wird anschließend mit Aceton in einem Spin Coater entfernt, wodurch die ringförmige Adhäsionszone als von der fluorierten Silanlösung unbehandelte Adhäsionszone zurückbleibt. Der Träger 10 mit Stützzone 11 ist fertiggestellt.

Auf diesen Träger 10 wird dann weitgehend vollflächig eine Basisschicht 20 aufgebracht. Insbesondere wird Basisschicht 20 später zumindest teilweise Teil des finalen Hybridwafers. In Einzelfällen ist es jedoch auch denkbar, dass diese Basisschicht zumindest teilweise bloß temporär während dem Aufbau der Chipstapel Verwendung findet. In diesem Fall würde diese Schicht zu einem späteren Zeitpunkt an geeigneter Stelle im gesamten Fertigungsprozessfluß wieder weitgehend vollständig entfernt. In diesem Zusammenhang ist weitgehend vollständig als Entfernung von zumindest 99,5% idealer jedoch 99,9% oder noch idealer 99,99% der ursprünglich vorhandenen Schicht anzusehen. Im Zusammenhang mit dieser nur temporär verwendeten Basisschicht lassen sich besonders vorteilhafte Träger realisieren, wenn diese Basisschicht zum Herstellen von elektrisch leitfähigen, metallischen Verbindungen benutzt wird, die später durch Entfernen der Schicht freigelegt und damit zugänglich gemacht werden können. Derartige Prozesse sind in der Halbleiterindustrie üblich und unter dem Begriff "Sacrificial Layer" bekannt. Um derartige Strukturen realisieren zu können, kann es je nach Ausgestaltung dieser Strukturen von Vorteil sein, wenn diese Basisschicht aus einem photostrukturierbaren Material besteht. In diesem Zusammenhang ist weitgehend vollflächig als mindestens 90% der Stützzone 11 mit der reduzierten Klebestärke zu verstehen. In optimierten Ausführungsformen ist beträgt diese Fläche jedoch mindestens 98% oder ist noch idealer größer als die Stützzone 11. Bei dem Durchmesser von 300mm des kreisförmigen Trägers 10 weist die Adhäsionszone 14 mit der hohen Klebekraft typischerweise eine Ringbreite von >0,5mm, idealerweise >1mm und noch idealer >2mm oder >4mm auf.

In dem Fall, dass die Basisschicht 20 eine größere Fläche bedeckt als Stützzone 11, ist es gemäß Ausführungsform F bevorzugt, wenn der Träger 10 einen Absatz 12 im Bereich der hohen Klebekraft aufweist. Dieser Absatz 12 wird vor dem Aufbringen der Basisschicht 20 mit einem Füllmaterial 13 aufgefüllt, bis das Füllmaterial 13 bündig mit der Stützzone 11 eine ebene Trägerseite 15 bildet. Dabei wird als Füllmaterial 13 idealerweise ein Material gewählt, das sich später durch gezielte Einwirkung von außen selektiv lösen oder entfernen lässt. Als derartige Mechanismen für die Einwirkung kommen mechanische, optische und chemische Verfahren oder eine Kombination dieser Verfahren in Frage. Beispielsweise könnten also Materialien, insbesondere Kunststoffe verwendet werden, die sich mittels eines bestimmten Lösungsmittels lösen lassen. Es wären auch anorganische Materialien möglich, die sich mittels einer speziellen Ätzchemie lösen lassen. Weiterhin wären auch Materialien denkbar, die sich unter Einwirkung von Ultraviolett-(UV)-Strahlung oder Infrarot-(IR)-Strahlung lösen lassen. Der Absatz 12 ist dabei so gestaltet, dass die Stützzone 11 mit geringer Haltekraft etwa, insbesondere genau, bis zu einer Stufe 17 des Absatzes 12 reicht. Die Stufe 17 kann entweder in Form einer rechtwinkeligen Kante oder auch einer schräg verlaufenden Kante ausgebildet sein. Mit Vorteil ist es möglich, derart schräg verlaufende Kanten mittels Nassätzprozess herzustellen, wobei es die Kristallstruktur von Silizium ermöglicht, derartige schräge Kanten automatisch herzustellen.

Die Basisschicht wird erfindungsgemäß entweder mittels Spin- oder Sprühbelacken oder Laminieren oder Rakeln, Gießen, oder Extrusionsbelacken aufgebracht.

In einem nicht beanspruchten Beispiel ist das Material der Basisschicht 20 ein photostrukturierbares Material, insbesondere ein photostrukturierbares Dielektrikum. Beispielsweise könnten hier Benzocyclobuten, WPR 5100 (von JSR®), SiNR® von ShinEtsu Chemicals® oder ähnliche Produkte von Hitachi Chemicals oder Sumitomo Bakelite, sowie Polyimide zum Einsatz kommen. Der Fachmann kennt derartige Materialien und vermag diese entsprechend den durch die Endanwendung und den Fertigungsprozessfluss definierten Anforderungen auszuwählen. In einer bevorzugten Ausführungsform (A, B, C, D und H) können nun aufbauend auf der Basisschicht 20 Leiterbahnen 21 für die nötigen Verdrahtungsebenen der Chips 30 hergestellt werden. Dies geschieht in der Regel mittels Lithographie und additiven Prozessen. Beispielsweise kann die Isolation zwischen den einzelnen Leitern mit den zuvor genannten photosensitiven, dielektrischen Materialien hergestellt werden, während die metallischen Verbindungen mittels Barrier Seed Deposition (Sputtering) und elektrochemischer Abscheidung (Elektroplating) hergestellt werden können. Diese Prozesse sind in der Industrie üblich und dem Fachmann bekannt. Im Anschluss daran werden Kontaktpads 22 hergestellt, die später dazu dienen werden, die Chips 30 aufzunehmen und zu kontaktieren. Zusammen mit diesen Kontaktpads 22 werden Idealerweise auch Justiermarken 25 vorgesehen, die ein genaues Justieren der Chips 30 relativ zu der Basisschicht 20 ermöglichen. Damit kann auf ein externes Justiermittel verzichtet werden, was zu einer erheblich genaueren Justierung der Chips 30 führt.

In der nicht beanspruchten Alternative G wird die Basisschicht 20 lediglich belichtet und nach dem Belichten einem Ausheizprozess ("Post Exposure Bake") unterzogen. Diese Sequenz führt dazu, dass im Falle eines Negativresists die belichteten Stellen chemisch vernetzen, und damit für die Entwicklerflüssigkeit unlösbar werden, während die unbelichteten Stellen lösbar bleiben. Bei einem Positivlack verhält sich dies genau umgekehrt: Die belichteten Stellen werden besser im Entwickler lösbar, während die unbelichteten Stellen schwer lösbar bleiben. Es sei hier der Vollständigkeit halber angemerkt, dass die meisten Dielektrik-Materialien das Verhalten eines Negativlacks haben. Es können dann direkt auf die somit bereits belichtete Basisschicht 20 die Verbindungslagen analog den Prozessen A, B, C, D und H aufgebaut werden, oder direkt auf die Basisschicht 20 Chips 30 platziert werden. In diesem Fall kann es sich als Vorteil erweisen, die Chips 30 vor dem Ausheizen des belichteten Dielektrikums aufzubringen, und später den Vernetzungsprozess mit Vorteil auch dazu zu benutzen, eine permanente Klebeverbindung (Bondverbindung) zwischen den Chips 30 und dem Dielektrik-Material der Basisschicht 20 zu erhalten (Ausführungsform G).

Eine weitere alternative Ausführungsform (Prozessfluß F gemäß Figuren 9F1 bis 9F7) sieht vor, dass die Chips 30 lediglich auf die Basisschicht 20 aufgeklebt werden. Dies kann entweder unter Zuhilfenahme eines zusätzlichen Klebers geschehen oder unter Nutzung etwaiger Klebeeigenschaften des entsprechend gewählten Materials der Basisschicht 20. Es ist erfindungsgemäß denkbar, dass die Chips 30 mittels eines sogenannten Die Attach Adhesives verklebt werden. Alternativ könnte das Material der Basisschicht 20 ein Dielektrikum, insbesondere eines der zuvor beschriebenen Materialen sein, welches im unbelichteten Zustand weitgehend das Verhalten eines Thermoplasts hat. Damit könnten die Chips 30 mittels eines thermomechanischen Klebeverfahrens fixiert werden.

Für die nicht beanspruchten Beispiele A, B, C, D und für die Ausführungsform H werden nach dem Herstellen der Kontaktpads 22 die Chips 30 oder aus jeweils mindestens einem Chip 30 gebildeten Chipstapel 31 platziert. Dies kann mittels gängiger Chip-to-Wafer Bondverfahren geschehen, wobei typischerweise die Chips 30 mittels eines temporären Klebers vorfixiert werden und erst später in einem Reflow Prozess ein permanenter Bond geformt wird. Die Ausführungsformen A und B stellen in diesem Zusammenhang eine Variante mit bumps 36 dar, bei denen die Chips 30 mittels Flussmittel oder No-Flow-Underfill fixiert werden. Erst nachdem alle Chips 30 auf der Basisschicht 20 platziert sind, durchläuft der Träger 10 mit der Vielzahl der vorfixierten Chips 30 einen thermischen Prozess ("Reflow Prozess") bei dem die bumps 36 und die Kontaktpads 22 miteinander verlötet werden. Dabei stellt das Flussmittel sicher, dass es zu keiner Oxidation der Kontaktflächen während des Heizens kommt. Alternativ kann ein sogenanntes No-flow underfill dieselbe Funktion übernehmen, das auch später permanenter Teil des Bond Interfaces zwischen den Chips 30 bleibt und so für eine verbesserte mechanische Stabilität Sorge trägt. Somit erspart das No-Flow Underfill das spätere (in Prozess A und B dargestellte) Unterfüllen von Spalten zwischen den Chips 30. Bei Verwendung von derartigen No-Flow Underfill Materialien ist es auch häufig notwendig, während dem thermischen Prozess Druck auf die Chips auszuüben, was mit Vorteil mittels einer Druckplatte geschieht, die gleichzeitig Druck auf alle, am Träger befindlichen Chips ausüben kann.

In den nicht beanspruchten Beispiele C, D und in der Ausführungsform H sind Verbindungen dargestellt, die auf bumps 36 verzichten, und stattdessen planare Flächen verwenden. Dies ermöglicht in weiterer Folge dichtere Verbindungen, da auf die ansonsten üblichen Bumps 36 verzichtet wird. Diese spezielle Form der Verbindung wird üblicherweise mittels sogenannter "Transient Liquid Phase (TLP)" Bonding Prozesse hergestellt. Dabei werden eutektische Metallverbindungen geschaffen, bei denen ein erstes Metall aus der flüssigen Phase in ein zweites Metall diffundiert und mit diesem stabile intermetallische Verbindungen mit einem Schmelzpunkt, der über dem des ersten Metalls liegt, bildet. Damit lassen sich Bondverbindungen bei niedriger Temperatur realisieren, die später einen Schmelzpunkt aufweisen, der über der ursprünglichen Bondtemperatur liegt. Dies macht diese Verbindungen besonders geeignet für das Stapeln von mehreren Chiplagen 33 von Chips 30, da damit die Verbindungen der bereits verbondeten Ebenen nicht mehr beeinträchtigt werden. Eine typisches Beispiel für eine derartige Bondverbindung wären Verbindungen aus Kupfer und Zinn. Weitere Möglichkeiten wären aber auch Kupfer und Indium, Gold und Zinn, Nickel und Zinn und Gold und Indium. So ist beispielsweise die Bondtemperatur für ein derartiges Kupfer-Zinn Bondinterface in etwa bei 270 bis 280°C, während das komplettierte Interface eine Temperaturstabilität von zumindest 415°C aufweist. Die in den Prozessflüssen C, D und H dargestellten Chips 30 und Chipstapel 31 werden vor dem thermischen Prozess mittels eines temporären Klebers fixiert, welcher später bei dem thermischen Prozess zur Herstellung des permanenten metallischen Bonds verdampft. Es bietet sich hier beispielsweise die Verwendung von Bibenzyl an. Dabei ist es möglich, die Chipstapel 31 entweder Chiplage 33 für Chiplage 33 in mehreren Schritten bestehend aus jeweils Chipplatzierung und thermischem Prozess zur Formung des permanenten Bond Interfaces oder aus einem einzigen Platzierschritt und einem einzigen thermischen Prozessablauf herzustellen. Dasselbe gilt analog auch für die Prozessabläufe A und B.

In weiterer Folge werden die Chipstapel 31 optional zum Erreichen einer verbesserten mechanischen Stabilität mittels Underfill Material unterfüllt. Alternativ ist es auch denkbar, anstatt des zuvor beschriebenen temporären Klebers ein Material zu verwenden, welches nach dem Komplettieren des thermischen Prozesses zum Hersteiien der metallischen Verbindungen permanenter Teil des Chipstapels bleibt. Insbesondere könnte das Material wieder ein sogenanntes No-Flow-Underfill Material sein oder ein geeignetes anderes Material aus der Gruppe der zuvor genannten Dielektrika. Auch Hybridbond Interfaces bestehend aus einer metallischen Kontaktfläche, welche von einer nichtmetallischen, elektrisch isolierenden Region umgeben sind, sind denkbar. Ein Beispiel dafür wären metallische Kontaktflächen, die von Siliziumoxid umgeben sind. Dabei kann das Siliziumoxid mit entsprechend guter Qualität auch dazu dienen, die Chips bei Raumtemperatur mittels Van-der-Waals Bonds zu fixieren, welche später durch einen thermischen Prozess zu einer permanenten Bondverbindung konvertiert werden.

In den Prozessen E und F werden die Chips 30 untereinander mittels geeigneter Verfahren verbunden. Beispielsweise können das Lithographieverfahren sein, wie in der nicht beanspruchten Alternative F dargestellt. Dabei können wieder Materialien und Verfahren wie oben beschrieben zum Einsatz kommen. Insbesondere ist hier das Aufbringen der Dielektrika mittels Sprühbelacken geeignet, um die Chips einbetten zu können, sowie um die signifikante Topographie, die durch die Chips 30 gebildet wird, planarisieren zu können.

Die nicht beanspruchte Alternative E zeigt eine Variante, wo zumindest ein Teil der Verbindungen auch mittels Wire Bonding hergestellt wird.

Diese beiden Varianten E und F sollen die Flexibilität des Verfahrens zeigen, und deutlich machen, dass die vorliegende Erfindung ein äußerst universelles Verfahren ist, welches es ermöglicht, eine Vielzahl von Verbindungstechnologien mit einzubinden.

Nach dem Fertigstellen jeglicher Verbindungen und dem Underfill Prozess werden die verbleibenden Freiräume mit einer Eingießverbindung (molding compound) aufgefüllt. Diese dient zur Stabilisierung und insbesondere zur Vergrößerung der Chips/Chipstapel.

Die Ausnahme bildet hier die nicht beanspruchte Alternative F, bei der auf molding compounds verzichtet wird, wodurch besonders dünne und kompakte Packages erzielt werden können. Wenn in diesem Fall die Chipstärken entsprechend dünn gewählt werden, sowie die Dielektrik-Materialien eine entsprechende mechanische Robustheit aufweisen, kann dies ein mechanisch sehr flexibles (biegsames) Package aus in ein dem Material der Basisschicht 20 entsprechendes Schichtmaterial 40 eingegossenen Chipstapeln 31 ermöglichen, welche besonders für spezielle Anwendungen, wo diese Flexibilität von Vorteil ist, geeignet sind. Beispielsweise könnten dies Smart Card Anwendungen sein oder Anwendungen wo das Package auf eine gebogene Fläche montiert werden soll.

Am Anschluss an den Eingießschritt wird der Hybridwafer 34 vom Träger 10 gelöst. Mit Vorteil ist dies möglich, wenn der Träger 10 wie in Ausführungsform H beschrieben ausgestaltet ist. In diesem Fall wird zuerst das als geeigneter Kleber ausgebildete Füllmaterial 13 gelöst. Im Anschluss kann dann der Hybridwafer 34 vom Träger 10 abgehoben werden. Mit Vorteil geschieht dieses Abheben in einer Art und Weise, wo entweder die Flexibilität des Trägers 10 und / oder des Hybridwafers 34 derart genutzt wird, dass der Abhebeprozess von einer definierten Stelle gestartet wird, und eine Trennwelle vom Startpunkt über die gesamte Fläche läuft und letztendlich den Hybridwafer 34 vom Träger 10 separiert. Zumindest jedoch muss die Trennwelle vom Rand zum Zentrum des Trägers 10 laufen. Um den Start dieser Trennwelle zu begünstigen und/oder zu initiieren, kann es hilfreich und erforderlich sein, dass ein mechanisches Trennelement in das Interface zwischen Träger 10 und Hybridwafer 34 eingeführt wird. Dies könnte beispielsweise in Keil oder ein Kegel oder eine Klinge sein. Auch ein gespannter Draht mit geeignetem Querschnitt ist denkbar. Alternativ könnte der Trennprozess mittels Wasser oder Gasstrahl initiiert und/oder unterstützt werden.

Der Verfahrensablauf bei der nicht beanspruchten Alternative F ist gemäß Figuren 9F1 bis 9F7 wie folgt:
In dem in Figuren 9F1 gezeigten Verfahrensschritt ist auf dem Träger 10 mit seiner die Stützzone 11 bildenden Füllschicht 19 die Basisschicht 20 aufgebracht. Die Basisschicht 20 bedeckt die Stützzone 11 vollständig und überragt diese geringfügig. Der die Stützzone 11 überragende ringförmige Abschnitt der Basisschicht 20 liegt am vollständigen Umfang der Basisschicht 20 auf der Adhäsionszone 14 auf, die eine mindestens um den Faktor 3 stärkere Adhäsionskraft als die Adhäsionszone pro Flächeneinheit aufweist. Somit wird die Basisschicht 20 im wesentlichen ausschließlich in der Adhäsionszone 14 gehalten.

Anschließend werden - wie in Figur 9F2 gezeigt - Chips 30 auf der dem Träger 10 abgewandten Seite der Basisschicht 20 auf die Basisschicht 20 aufgebracht, und zwar mit einem Pick-and-Place-Tool. An der der Basisschicht 20 abgewandten Seite der Chips 30, die mehrlagig aufgebracht werden können, sind Kontaktpads 22 aufgebracht, die der späteren Kontaktierung durch Leiterbahnen 21 (siehe Figur 9F4) in Form von Fan-Out-Kontaktierungsstrukturen dienen.

Im in Figur 9F3 gezeigten Schritt wird ein dem Material der Basisschicht 20 entsprechendes Schichtmaterial 40 vollflächig auf die Basisschicht 20 aufgetragen, wobei das Schichtmaterial 40 beim Auftragen derart ausgebildet ist, dass es in die zwischen den Chipstapeln 31 gebildeten Freiräume ohne Blasenbildung eindringt.

In dem in Figuren 9F4 gezeigten Verfahrensschritt werden, insbesondere schichtweise, Leiterbahnen 21 aufgebaut, die zur Kontaktierung der Kontaktpads 22 und/oder benachbarter Chips 30 ausgebildet sind. Die Leiterbahnen können durch Lithografieschritte oder durch ein Prägeverfahren hergestellt werden.

In dem in Figur 9F5 gezeigten Verfahrensschritt werden die zur Kontaktierung einer Leiterplatte vorgesehenen Fan-Out-Kontaktierungsstrukturen 21 aus dem Schichtmaterial 40 herausgeführt, wobei Anschlüsse der Fan-Out-Kontaktierungsstrukturen 21 mit Anschlussbumps 50 versehen sind, die zum Anschluss des Hybridwafers 34 gemäß Figur 9F7 an eine korrespondierende Leiterplatte dienen.

In dem in Figuren 9F6 gezeigten Schritt ist der Träger 10 von der Basisschicht 20 entfernt worden und zwar im wesentlichen durch Einwirkung auf die Adhäsionszone 14 in der oben beschriebenen Art und Weise.

In der Figur 9F7 ist ein vereinzelter Chipstapel 31 gezeigt, bei dem ein ebenfalls vereinzeltes Basisteil 26 der Basisschicht 20 als Träger dient.

Die Figuren 10G1 bis 10G11 zeigen die Herstellung gemäß der nicht beanspruchten Alternative G. Der erste Verfahrensschritt gemäß Figur 10G1 entspricht dem Verfahrensschritt gemäß Figur 9F1, ebenso wie den in Figuren 1A, 1B, 1C, 1D und 1E gezeigten Verfahrensschritten.

Im Verfahrensschritt gemäß Figur 10G2 wird eine Fotomaske 90 zur Lithografiebehandlung ausgerichtet über der Basisschicht 20 angeordnet und in dem Verfahrensschritt gemäß Figur 10G3 wird die Basisschicht 20 durch die Fotomaske 90 hindurch belichtet.

Im Bereich der belichteten Belichtungsstellen 27 der Basisschicht 20 werden gemäß Figur 10G4 über Kontaktpads 22 Chips 30 zu Chiplagen 31 aufgebaut, wobei Chipjustiermarken 38 am Chiprand 37 zur Ausrichtung der Chips 30 zueinander und zu der Basisschicht 20 dienen.

Im Verfahrensschritt gemäß Figur 10G5 werden die Chips 30 mit einem Schichtmaterial 40 eingegossen, und zwar vollflächig auf der Basisschicht 20.

Im Verfahrensschritt gemäß Figur 10G6 wird der Träger 10 analog Figur 9F6 entfernt und in dem Verfahrensschritt gemäß Figur 10G7 wird der Hybridwafer 34 auf den Kopf gestellt, also umgedreht.

Im Verfahrensschritt gemäß Figur 10G8 werden die Belichtungsstellen 27 der Basisschicht 20 freigelegt, insbesondere durch Ätzen, woraufhin im Verfahrensschritt gemäß Figur 10G9 die Leiterbahnen 21 in den freigelegten Belichtungsstellen 27 ausgebildet werden.

Im Verfahrensschritt gemäß Figur 10G10 werden Anschlussbumps 50 zum Anschluss der Chipstapel 31 an eine Leiterplatte mit den Leiterbahnen 21 kontaktiert.

Im Verfahrensschritt gemäß Figur 10G11 werden die Chipstapel 31 des Hybridwafers 31 vereinzelt.

In der erfindungsgemäßen Ausführungsform H gemäß Figuren 11H1 bis 11H9 wird die Basisschicht 20 gemäß Figur 11H1 analog dem Verfahren gemäß Figur 9F1 aufgebracht mit dem Unterschied, dass der Träger 10 in der Adhäsionszone 14, also an die Stützzone 11 anschließend einen Absatz 12 aufweist, der gegenüber der Trägerseite 15 zurückspringt, quasi eine Schulter bildet. Bevor die Basisschicht 20 auf den Träger 10 aufgebracht wird, wird der Absatz 12 mit einem adhäsiv wirkenden Füllmaterial 13 verfüllt, so dass das Füllmaterial 13 bündig mit der Stützzone 11 ausgebildet ist. Die Basisschicht 20liegt zumindest teilweise auf dem Füllmaterial 13 in einem Ringabschnitt der Oberseite des Füllmaterials 13 auf. Das Füllmaterial 13 bildet damit zumindest teilweise die Adhäsionszone 14.

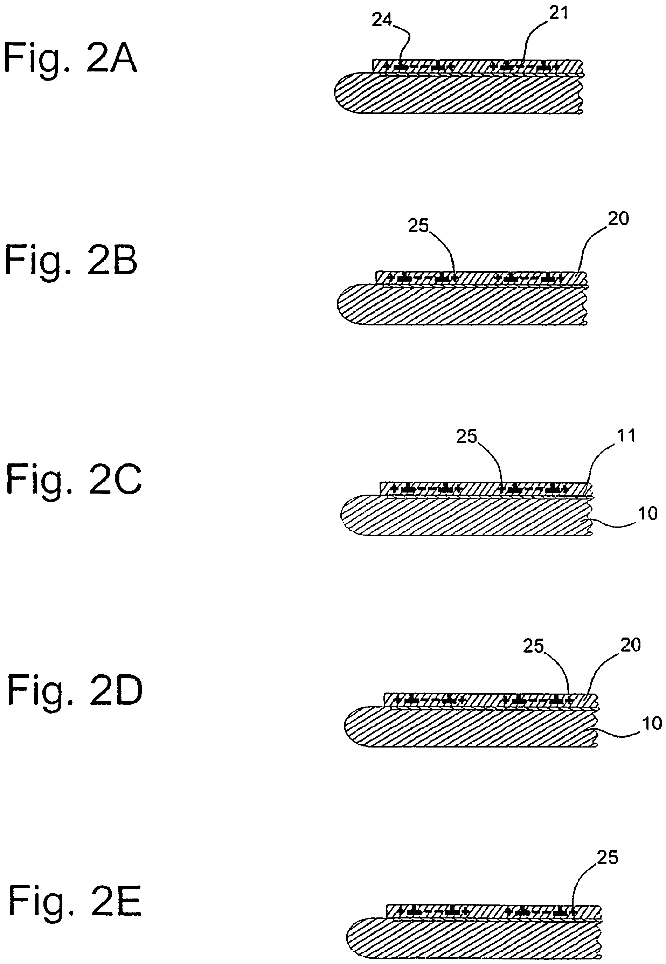

Der Verfahrensschritt gemäß Figur 11H2 entspricht dem Verfahrensschritt gemäß Figur 2D (nicht beanspruchte Alternative D), in welchem die Leiterbahnen 21 und die Justiermarken 25 in der Basisschicht 20 ausgebildet werden.

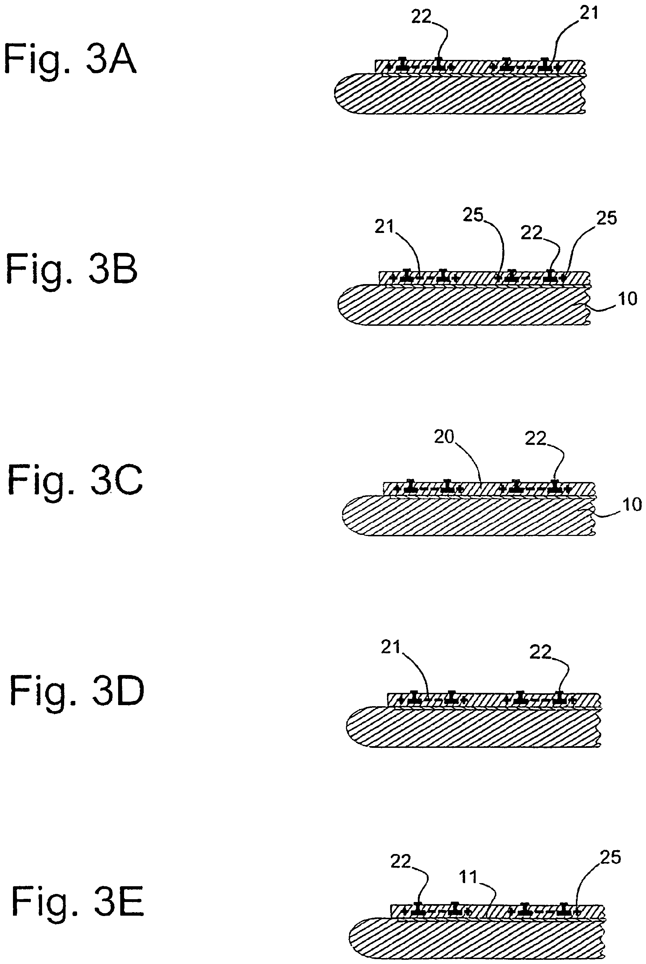

Der Verfahrensschritt gemäß Figur 11H3 entspricht dem Verfahrensschritt gemäß Figur 3D, in welchem die Kontaktpads 22 auf die Basisschicht 20 aufgebracht werden, und zwar an Kontaktstellen zu den Leiterbahnen 21, die gleichzeitig die Fan-Out-Kontaktierungsstrukturen bilden.

Der Verfahrensschritt gemäß Figur 11H4 entspricht dem Verfahrensschritt gemäß Figur 4D, bei dem die Chipstapel 31 durch Stapeln von Chips 30 in vier Chiplagen 33 gebildet werden. Die Chips 30 der Chiplagen 33 werden durch TSVs und die jeweiligen TSVs verbindende Kontakte miteinander zusammengeschaltet.

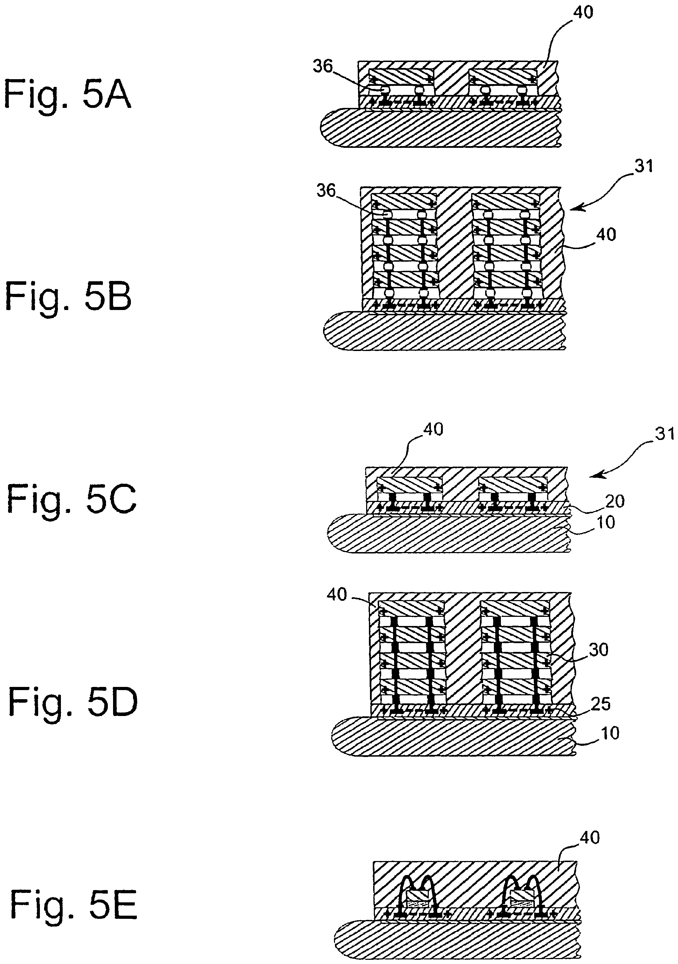

In dem Verfahrensschritt gemäß Figur 5D entsprechenden Verfahrensschritt gemäß Figur 11H5 werden die Chipstapel 31 durch Schichtmaterial 40 eingegossen.

Im Verfahrensschritt gemäß Figur 11H6 wird das Füllmaterial 13 durch korrespondierendes Lösungsmittel, das selektiv gegenüber dem Füllmaterial 13 wirkt, entfernt, so dass in dem sich anschließenden Verfahrensschritt gemäß Figur 11H7 der Träger 10 ohne weiteres von dem Hybridwafer 34 gelöst werden kann.

Im Verfahrensschritt gemäß Figur 11H8 werden Anschlussbumps 50 an der Basisschicht 20 mit den korrespondierenden Kontaktstellen der Fan-Out-Kontaktstrukturen kontaktiert.

Im Verfahrensschritt gemäß Figur 11H9 werden die Chipstapel 31 vereinzelt.

### Bezugszeichenliste

10 Träger
11 Stützzone
12 Absatz
13 Füllmaterial
14 Adhäsionszone
15 Trägerseite
16 Seitenrand
17 Stufe
18 Kontaktfläche
19 Füllschicht
20 Basisschicht
21 Leiterbahnen
22 Kontaktpads
24 Chipseite
25 Justiermarken
26 Basisteile
27 Belichtungsstellen
30 Chips
31 Chipsstapel
32 Chipstapelrand
33 Chiplage
34 Hybridwafer
35 Hybridwaferrand
36 bumps
37 Chiprand
38 Chipjustiermarken
40 Schichtmaterial
50 Anschlussbumps
90 Fotomaske

## Patentansprüche

1. Verfahren zur Herstellung von Chipstapeln (31) mit folgendem Verfahrensablauf:
- Aufbringen mittels Spin- oder Sprühbelacken oder Laminieren oder Rakeln oder Gießen oder Extrusionsbelacken einer Basisschicht (20) auf eine Trägerseite (15) eines Trägers (10), der an seiner Trägerseite (15) mit einer adhäsiv wirkenden Adhäsionszone (14) sowie einer weniger adhäsiv wirkenden Stützzone (11) versehen ist, wobei der Träger (10) an der Trägerseite (15) in der Adhäsionszone (14) einen Absatz (12) aufweist, der gegenüber der Trägerseite (15) zurückgesetzt ist und mit einem adhäsiv wirkenden, selektiv lösbaren Füllmaterial (13) so verfüllt ist, dass das Füllmaterial (13) bündig mit der Stützzone (11) ausgebildet ist, wobei die Basisschicht (20) zumindest überwiegend auf die Stützzone (11) aufgebracht wird,
- Aufbauen der Chipstapel (31) auf der Basisschicht (20), wobei die Basisschicht (20) zumindest teilweise Bestandteil der Chipstapel (31) wird,
- Selektives Entfernen des Füllmaterials (13) durch ein Lösungsmittel, und
- Lösen des Trägers (10) von der Basisschicht (20).

2. Verfahren nach Anspruch 1, bei dem die Basisschicht (20) vollflächig auf die Stützzone (11) und zumindest teilweise auf die Adhäsionszone (14) aufgebracht wird.

3. Verfahren nach Anspruch 1, bei dem die Chipstapel (31) vor dem Lösen des Trägers (10) vereinzelt werden, insbesondere durch Schneiden, so dass die Chipstapel (31) nur noch mit dem Träger (10) verbunden sind.

4. Verfahren nach Anspruch 1, bei dem das die Basisschicht (20) bildende Material flexibel ist.

5. Verfahren nach Anspruch 1, bei dem, insbesondere vor dem Aufbauen der Chipstapel (31), fan-out-Kontaktierungsstrukturen (21) in die Basisschicht (20) eingebracht werden.

6. Verfahren nach Anspruch 5, bei dem vor dem Aufbauen der Chipstapel (31) an einer der Trägerseite (15) abgewandten Chipseite (24) Kontaktpads (22) zur elektrischen Kontaktierung der Chipstapel (31) mit den fan-out-Kontaktierungsstrukturen (21) aufgebracht werden.

7. Verfahren nach Anspruch 6, bei dem vor oder beim Aufbauen der Chipstapel (31), insbesondere gleichzeitig mit dem Einbringen der fan-out-Kontaktierungsstrukturen (21) gemäß Anspruch 5, Justiermarken (25) zur Positionierung/Platzierung der Kontaktpads (22) und oder der Chipstapel (31) auf der Basisschicht (20), insbesondere jeweils fluchtend zu einem Chipstapelrand (32) der Chipstapel (31), in/auf der Basisschicht (20) vorgesehen werden.

8. Verfahren nach Anspruch 1, bei dem die Chipstapel (31) durch Kleben direkt auf die Basisschicht (20) aufgeklebt werden.

9. Verfahren nach einem der vorhergehenden Ansprüche, bei dem nach dem Aufbauen der Chipstapel (31) und vor dem Lösen des Trägers (10) die Chipstapel mit einem, insbesondere dem Material der Basisschicht (20) entsprechenden, Schichtmaterial (40) eingegossen werden.

10. Verfahren nach Anspruch 1 , bei dem das Lösen des Trägers (10) von einem Seitenrand des Trägers (10) her, insbesondere durch Verringerung der Adhäsionskraft der Adhäsionsschicht (14), vorzugsweise durch selektives Lösen des Füllmaterials (13), erfolgt.

11. Verfahren nach einem der vorhergehenden Ansprüche, bei dem Basisteile (26) der Basisschicht (20) einen Teil jedes Chipstapels (31) bilden.

12. Träger (10), der an einer Trägerseite (15) mit einer adhäsiv wirkenden Adhäsionszone (14) sowie einer weniger adhäsiv wirkenden Stützzone (11) versehen ist, wobei mittels Spin- oder Sprühbelacken oder Laminieren oder Rakeln oder Gießen oder Extrusionsbelacken eine Basisschicht (20) zumindest überwiegend auf die Stützzone (11) aufgebracht ist, und wobei der Träger (10) an der Trägerseite (15) in der Adhäsionszone (14) einen Absatz (12) aufweist, der gegenüber der Trägerseite (15) zurückgesetzt ist und mit einem adhäsiv wirkenden, selektiv lösbaren Füllmaterial (13) so verfüllt ist, dass das Füllmaterial (13) bündig mit der Stützzone (11) ausgebildet ist.

## Claims

1. A method of producing chip stacks (31) with the following process sequence:
- application, by means of spin coating or spray coating or lamination or blade coating or casting or extrusion coating, of a base layer (20) on a carrier side (15) of a carrier (10), which is provided at its carrier side (15) with an adhesively active adhesion zone (14) and a less adhesively active support zone (11), wherein the carrier (10) comprises a recess (12) at the carrier side (15) in the adhesion zone (14), which recess is set back relative to the carrier side (15) and is filled with an adhesively active, selectively releasable filler material (13), in such a way that the filler material (13) is constituted flush with the support zone (11), wherein the base layer (20) is applied at least predominantly on the support zone (11),
- setting-up of the chip stacks (31) on the base layer (20), wherein the base layer (20) becomes at least in part a component of the chip stacks (31),
- selective removal of the filler material (13) by means of a solvent, and
- detachment of the carrier (10) from the base layer (20).

2. The method according to claim 1, wherein the base layer (20) is applied over the full area on the support zone (11) and at least partially on the adhesion zone (14).

3. The method according to claim 1, wherein the chip stacks (31) are separated before the detachment of the carrier layer (10), in particular by cutting, so that the chip stacks (31) are now only connected to the carrier (10).

4. The method according to claim 1, wherein the material forming the base layer (20) is flexible.

5. The method according to claim 1, wherein, in particular before the setting-up of the chip stacks (31), fan-out contacting structures (21) are introduced into the base layer (20).

6. The method according to claim 5, wherein, before the setting-up of the chip stacks (31), contact pads (22) for the electrical contacting of the chip stacks (31) with the fan-out contacting structures (21) are provided at a chip side (24) facing away from the carriers side (15).

7. The method according to claim 6, wherein, before or during the setting-up of the chip stacks (31), in particular simultaneously with the introduction of the fan-out contacting structures (21) according to claim 5, adjustment marks (25) for the positioning/placing of the contact pads (22) and/or the chip stacks (31) on the base layer (20), in particular in each case flush with a chip stack edge (32) of the chip stacks (31), are provided in/on the base layer (20).

8. The method according to claim 1, wherein the chip stacks (31) are bonded directly onto the base layer (20) by adhesive bonding.

9. The method according to any one of the preceding claims, wherein, after the setting-up of the chip stacks (31) and before the detachment of the carrier (10), the chip stacks are cast with a layer material (40) corresponding in particular to the material of the base layer (20).

10. The method according to claim 1, wherein the detachment of the carrier (10) takes place from a side edge of the carrier (10), in particular by reducing the adhesive strength of the adhesion layer (14), preferably by selective dissolving of the filler material (13).

11. The method according to any one of the preceding claims, wherein base parts (26) of the base layer (20) form a part of each chip stack (31).

12. A carrier (10), which is provided on a carrier side (15) with an adhesively active adhesion zone (14) and a less adhesively active support zone (11), wherein a base layer (20) is applied at least predominantly on the support zone (11) by means of spin coating or spray coating or lamination or blade coating or casting or extrusion coating, and wherein the carrier (10) comprises a recess (12) at the carrier side (15) in the adhesion zone (14), which recess is set back relative to the carrier side (15) and is filled with an adhesively active, selectively dissolvable filler material (13), in such a way that the filler material (13) is constituted flush with the support zone (11).

## Revendications

1. Procédé de fabrication de piles de puces (31) comprenant le déroulement suivant :
- application par revêtement par rotation ou pulvérisation ou laminage ou raclage ou coulée ou revêtement par extrusion d'une couche de base (20) sur un côté porteur (15) d'un support (10) qui est doté sur son côté porteur (15) d'une zone d'adhérence (14) agençant de manière adhésive ainsi que d'une zone d'appui (11) agissant de manière moins adhésive, dans lequel le support (10) sur le côté porteur (15) présente dans la zone d'adhérence (14), un retrait (12) qui est en retrait par rapport au côté porteur (15) et est ainsi rempli d'un matériau de remplissage (13) agissant de manière adhésive, séparable de manière sélective, que le matériau de remplissage (13) est conçu adjacent à la zone d'appui (11), dans lequel la couche de base (20) est appliquée au moins principalement sur la zone d'appui (11),
- montage des piles de puces (31) sur la couche de base (20), dans lequel la couche de base (20) devient au moins partiellement partie constituante des piles de puces (31),
- enlèvement sélectif du matériau de remplissage (13) par un solvant, et
- séparation du support (10) de la couche de base (20).

2. Procédé selon la revendication 1, dans lequel la couche de base (20) est appliquée sur toute la surface sur la zone d'appui (11) et est appliquée au moins partiellement sur la zone d'adhérence (14).

3. Procédé selon la revendication 1, dans lequel les piles de puces (31) sont différenciées avant la séparation du support (10), en particulier par découpe, de façon à ce que les piles de puces (31) ne soient plus reliées qu'au support (10).

4. Procédé selon la revendication 1, dans lequel le matériau formant la couche de base (20) est flexible.

5. Procédé selon la revendication 1, dans lequel des structures de mise en contact en éventail (21) sont insérées dans la couche de base (20), en particulier avant le montage des piles de puces (31).

6. Procédé selon la revendication 5, dans lequel, avant le montage des piles de puces (31) sur un côté des puces (24) détourné du côté porteur (15), des pastilles de contact (22) sont appliquées pour le contact électrique des piles de puces (31) avec les structures de mise en contact en éventail (21).

7. Procédé selon la revendication 6, dans lequel avant ou après le montage des piles de puces (31), en particulier parallèlement à l'insertion des structures de mise en contact en éventail (21) selon la revendication 5, des marquages d'ajustement (25) pour positionner/placer les pastilles de contact (22) et/ou des piles de puces (31) sur la couche de base (20), sont prévus dans/sur la couche de base (20), en particulier respectivement en affleurant à un bord de pile de puces (32) des piles de puces (31).

8. Procédé selon la revendication 1, dans lequel les piles de puces (31) sont collées directement par collage sur la couche de base (20).

9. Procédé selon l'une des revendications précédentes, dans lequel après le montage des piles de puces (31) et avant la séparation du support (10), les piles de puces sont coulées avec un matériau de couche (40), correspondant en particulier au matériau de la couche de base (20).

10. Procédé selon la revendication 1, dans lequel la séparation du support (10) s'effectue depuis un bord latéral du support (10), en particulier par réduction de la force d'adhérence de la couche d'adhérence (14), de préférence par une séparation sélective du matériau de remplissage (13).

11. Procédé selon l'une des revendications précédentes, dans lequel des parties de base (26) de la couche de base (20) forment une partie de chaque pile de puces (31).

12. Support (10) qui est doté sur un côté porteur (15) d'une zone d'adhérence (14) agissant de manière adhésive ainsi que d'une zone d'appui (11) agissant de manière sélective, dans lequel par application par revêtement par rotation ou pulvérisation, ou laminage ou raclage ou coulée ou revêtement par extrusion une couche de base (20) est appliquée au moins en majeure partie sur la zone d'appui (11), et dans lequel le support (10) sur le côté porteur (15) présente dans la zone d'adhérence (14) un retrait (12) est en retrait par rapport au côté porteur (15) et est ainsi rempli d'un matériau de remplissage (13) agissant de manière adhésive, séparable de manière sélective, que le matériau de remplissage (13) est conçu adjacent à la zone d'appui (11).
